# EUROPEAN PATENT SPECIFICATION

(11) **EP 3 886 126 B1**
(45) Date of publication and mention of the grant of the patent: **27.11.2024**
(21) Application number: 18943437.6
(22) Date of filing: 17.12.2018
(51) Int. Cl.: H01F 3/14, H01F 17/00

(54) **THIN-FILM INDUCTOR AND MANUFACTURING METHOD THEREFOR, INTEGRATED CIRCUIT AND TERMINAL DEVICE**
DÜNNSCHICHTSPULE UND HERSTELLUNGSVERFAHREN DAFÜR, INTEGRIERTE SCHALTUNG UND ENDGERÄT
INDUCTEUR À COUCHE MINCE ET SON PROCÉDÉ DE FABRICATION, CIRCUIT INTÉGRÉ ET DISPOSITIF TERMINAL

(43) Date of publication of application: 29.09.2021
(73) Proprietor: Huawei Technologies Co., Ltd., Shenzhen Guangdong 518129 (CN)
(72) Inventor: LIU, Ning, Shenzhen, Guangdong 518129 (CN); ZOU, Peng, Shenzhen, Guangdong 518129 (CN); LI, Hongwei, Shenzhen, Guangdong 518129 (CN); JIANG, Fan, Shenzhen, Guangdong 518129 (CN)
(74) Representative: Goddar, Heinz J.
(86) International application number: PCT/CN2018/121623
(87) International publication number: WO 2020/124341

(56) References cited:
- CN-A- 1 860 561
- CN-A- 102 568 797
- CN-A- 103 403 816
- CN-U- 204 375 745
- US-A1- 2013 176 095
- US-A1- 2018 358 166
- US-B1- 9 047 890

## Description

### TECHNICAL FIELD

This application relates to the field of electronic technologies, and in particular, to a thin film inductor and a preparation method thereof, an integrated circuit, and a terminal device.

### BACKGROUND

Miniaturization of an electronic component is a prerequisite for miniaturization of an electronic product. The electronic product may be a wearable device such as a band, a smart watch, or a Bluetooth headset; or a mobile display terminal such as a mobile phone or a tablet computer; or a device such as a server, an AI processor, or a network processor; or the like. A common electronic component includes an inductor.

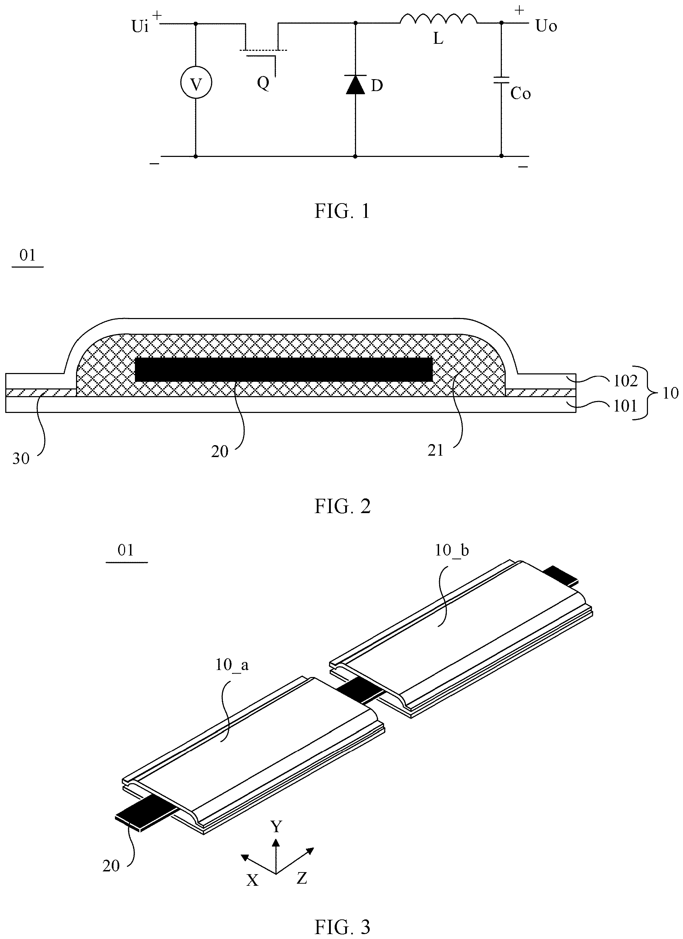

A voltage converter is usually disposed in the electronic product. In an example of a DC-DC buck circuit in the voltage converter, as shown in FIG. 1, an inductor L is disposed in the DC-DC buck circuit. The inductor L has an energy storage function and a filtering function. When a switch transistor Q is conducted, the inductor L is charged. When the switch transistor Q is cut off, the inductor L is discharged. In the buck circuit, when a switch frequency of the switch transistor Q is relatively low, for example, 1 KHz to 100 KHz, to reduce a ripple of a current output from the buck circuit, an inductance of the inductor L needs to be hundreds of µH to hundreds of nH. In this case, a size of the inductor L is too large to miniaturize the electronic product.
US 9 047 890 B1 discloses a thin film inductor having yokes, one or more of which is laminated, and one or more conductors passing between the yokes. The laminated yoke or yokes help reduce eddy currents and/or hysteresis losses. Magnetic layers of the laminated yoke have varying thickness, with the thickness of magnetic layers closer to the winding (that is, in areas of higher density magnetic flux) having relatively lower thickness(es) in order to further reduce eddy currents and related energy losses.
US 2013/176095 A1 discloses a thin film inductor having yokes, one or more of which is laminated, and one or more conductors passing between the yokes. The laminated yoke or yokes help reduce eddy currents and/or hysteresis losses. US 2018/358166 A1 discloses techniques for fabricating low-loss magnetic vias within a magnetic core. According to some embodiments, vias with small, well-defined sizes may be fabricated without reliance on precise alignment of layers. According to some embodiments, a magnetic core including a low-loss magnetic via can be wrapped around conductive coils of an inductor. The low-loss magnetic vias can improve performance of an inductive component by improving the quality factor relative to higher loss magnetic vias.

### SUMMARY

Embodiments of this application provide a thin film inductor and a preparation method thereof, an integrated circuit, and a terminal device, to resolve a problem of a relatively large size of an inductor in an electronic product.

To achieve the foregoing objectives, the invention provides a thin film inductor of claim 1 and a terminal device of claim 17. The following technical solutions are used in embodiments of this application:

According to a first aspect, a thin film inductor is provided. The thin film inductor includes a magnetic core, where the magnetic core includes a first magnetic film and a second magnetic film, and an accommodation cavity exists between the first magnetic film and the second magnetic film; a conductor, located in the accommodation cavity; and an insulating isolation film including regions, disposed on two sides of the conductor and located between the first magnetic film and the second magnetic film. The insulating isolation film is in contact with the first magnetic film and the second magnetic film. In addition, the first magnetic film and the second magnetic film each include magnetic sub-films and insulating sub-films. In the first magnetic film, the magnetic sub-films and the insulating sub-films are alternately disposed. In the second magnetic film, the magnetic sub-films and the insulating sub-films are alternately disposed. The magnetic sub-films and the insulating sub-films in the first magnetic film are exposed from a surface that is of the first magnetic film and that is in contact with the insulating isolation film; and/or the magnetic sub-films and the insulating sub-films in the second magnetic film are exposed from a surface that is of the second magnetic film and that is in contact with the insulating isolation film. In this way, an eddy current at the insulating isolation film can intersect the magnetic sub-films and the insulating sub-films that are exposed from the surface that is of the first magnetic film and that is in contact with the insulating isolation film, and/or the surface that is of the second magnetic film and that is in contact with the insulating isolation film. Therefore, the eddy current at the insulating isolation film is separated, at a position of a plane on which the eddy current is located and that intersects the layers of magnetic sub-films, into a plurality of sub-eddy currents by the layers of magnetic sub-films. Each sub-eddy current enters one layer of magnetic sub-film. In this case, each sub-eddy current can be limited to one layer of magnetic sub-film, to reduce loss of the eddy current.

Optionally, the surface that is of the first magnetic film and that is in contact with the insulating isolation film and/or the surface that is of the second magnetic film and that is in contact with the insulating isolation film is an inclined surface. In addition, the magnetic sub-films and the insulating sub-films in the first magnetic film and the second magnetic film are parallel to a lower surface of the first magnetic film. The lower surface of the first magnetic film is a surface that is of the first magnetic film and that is away from the second magnetic film. In this way, the eddy current can be separated, at the position of the plane on which the eddy current is located and that intersects the layers of magnetic sub-films, into the plurality of sub-eddy currents by the layers of magnetic sub-films. In addition, each sub-eddy current enters one layer of magnetic sub-film. In this case, each sub-eddy current can be limited to each layer of magnetic sub-film, to reduce loss of the eddy current.

Optionally, the surface that is of the first magnetic film and that is in contact with the insulating isolation film and the surface that is of the second magnetic film and that is in contact with the insulating isolation film are inclined surfaces with a same slope. In this case, a thickness of the insulating isolation film between the second magnetic film and the first magnetic film is the same at all positions.

Optionally, the first magnetic film is a trapezoidal frustum. An upper base of the trapezoidal frustum is close to the second magnetic film, and a lower base is away from the second magnetic film. In addition, the thin film inductor further includes a flattened dielectric layer, covering the upper base of the trapezoidal frustum and a part of side surfaces of the trapezoidal frustum; a magnetic flux hole, prepared on the flattened dielectric layer, where the insulating isolation film is located in the magnetic flux hole and covers the other part of the side surfaces of the trapezoidal frustum; and an interlayer dielectric layer, covering an upper surface of the flattened dielectric layer and a sidewall of the magnetic flux hole. The interlayer dielectric layer and the insulating isolation film are made of the same material and are an integrated structure. The flattened dielectric layer is configured to flatten a bearing surface configured to bear the conductor in the thin film inductor. The insulating isolation film in contact with the first magnetic film and the second magnetic film is formed in the magnetic flux hole. The interlayer dielectric layer is configured to form a part of a lower support layer below the conductor.

Optionally, a tail of the second magnetic film covers the sidewall on a side that is of the magnetic flux hole and that is away from the accommodation cavity, and an upper surface that is of the interlayer dielectric layer and that is connected to the sidewall, so that the tail of the second magnetic film has a turning. In addition, an end that is of the tail of the second magnetic film and that is away from the accommodation cavity has a taper angle. The taper angle is from 10° to 90°. In some embodiments of this disclosure, the taper angle β may be 12°, 15°, 19°, 20°, 30°, 60°, or 85°.

Optionally, the first magnetic film is a trapezoidal frustum. An upper base of the trapezoidal frustum is close to the second magnetic film, and a lower base is away from the second magnetic film. Side surfaces of the trapezoidal frustum are fully covered by the insulating isolation film. In addition, the thin film inductor further includes a flattened dielectric layer, covering the upper base of the trapezoidal frustum; and an interlayer dielectric layer, covering the flattened dielectric layer. The interlayer dielectric layer and the insulating isolation film are made of the same material and are an integrated structure. Technical effects of the flattened dielectric layer and the interlayer dielectric layer are the same as those described above. Details are not described herein again.

Optionally, an end that is away from the accommodation cavity and that is of a part that is of the second magnetic film and that is in contact with the insulating isolation film has a taper angle. The taper angle is less than 90°. The taper angle is from 10° to 90°. In some embodiments of this disclosure, the taper angle β may be 12°, 15°, 19°, 20°, 30°, 60°, or 85°. No turning needs to be disposed at the tail of the second magnetic film.

Optionally, the surface that is of the first magnetic film and that is in contact with the insulating isolation film and/or the surface that is of the second magnetic film and that is in contact with the insulating isolation film are/is curved surfaces/a curved surface. In addition, the magnetic sub-films and the insulating sub-films in the first magnetic film and the second magnetic film are parallel to the lower surface of the first magnetic film. The lower surface of the first magnetic film is a surface that is of the first magnetic film and that is away from the second magnetic film. In this way, a plurality of magnetic lines passing through the insulating isolation film are separately perpendicular to the surface that is of the first magnetic film and that is in contact with the insulating isolation film, that is, a tangent plane at a position of an intersecting point between each magnetic line and the curved surface. In this case, a sub-eddy current is induced in an alternating magnetic field at a section perpendicular to a direction of a magnetic line, that is, the tangent plane. Planes at which some sub-eddy currents are located respectively intersect film surfaces of the magnetic sub-films. Therefore, a sub-eddy current intersecting a film surface of a magnetic sub-film can enter the magnetic sub-film. In this case, the sub-eddy currents can be limited to the magnetic sub-films, to reduce loss of the eddy current.

Optionally, the surface that is of the first magnetic film and that is in contact with the insulating isolation film and the surface that is of the second magnetic film and that is in contact with the insulating isolation film are curved surfaces with same curvature. In this case, a thickness of the insulating isolation film between the second magnetic film and the first magnetic film is the same at all positions.

Optionally, the thin film inductor further includes a support pad. The support pad is located below the first magnetic film. A part below the first magnetic film is a side that is of the first magnetic film and that is away from the second magnetic film. An upper surface of the support pad is in contact with the insulating isolation film. In addition, the first magnetic film covers two sides of the upper surface of the support pad. In the first magnetic film covering the support pad, the magnetic sub-films and the insulating sub-films are in contact with the insulating isolation film. A surface that is of the support pad and that is in contact with the first magnetic film is a curved surface. In this case, the plurality of magnetic lines of the alternating magnetic field at a position of the insulating isolation film pass through the insulating isolation film from the second magnetic film, then separately enter the curved magnetic sub-films in the first magnetic film covering the support pad, and then go along a direction of laying the magnetic sub-films. The magnetic sub-films and the insulating sub-films in the first magnetic film covering the support pad intersect a surface at which the insulating isolation film is located. Paths of the plurality of magnetic lines are respectively limited to the layers of curved magnetic sub-films. Therefore, a plane in which an induced sub-eddy current is located and that is in a section perpendicular to a direction of each magnetic line in the alternating magnetic field also intersect the magnetic sub-films covering the support pad. In addition, the sub-eddy current is also limited to each layer of magnetic sub-film. In this way, the sub-eddy currents can be limited to the magnetic sub-films, to reduce loss of the eddy current.

Optionally, to simplify a process for preparing the support pad, the surface that is of the support pad and that is in contact with the first magnetic film is an arc surface. To improve stability of the support pad in the thin film inductor, a lower surface of the support pad is flush with a lower surface of the first magnetic film.

Optionally, the thin film inductor further includes: a seed layer, located in the accommodation cavity. The seed layer is in contact with a surface that is of the conductor and that is close to the first magnetic film. The seed layer is configured to set the conductor on the lower support layer. An upper support layer is located in the accommodation cavity. A surface of the conductor except the surface in contact with the seed layer is covered by the upper support layer. The upper support layer is configured to support the second magnetic film. The upper support layer can be used to adjust an overall thickness of the thin film inductor. An adhesion layer is disposed on a surface that is of the second magnetic film and that is close to the first magnetic film, and is configured to fasten the second magnetic film.

Optionally, a thickness of the insulating sub-film is from 5 nm to 50 nm. When the thickness of the insulating sub-film is less than 5 nm, and a switch frequency in a circuit is a high frequency, an impedance of a capacitor formed between the layers of magnetic sub-films is relatively small, so that sub-eddy currents in the magnetic sub-films easily pass through the insulating sub-films and converge, to reduce an effect of loss of the eddy current. In addition, when the thickness of the insulating sub-film is greater than 50 nm, if the first magnetic film or the second magnetic film is fixed, a proportion of a thickness of the magnetic sub-films in a thickness of the first magnetic film or the second magnetic film decreases, thereby reducing an effective magnetic permeability of the thin film inductor. In addition, the thickness of the magnetic sub-film is from 100 nm to 500 nm. When the thickness of the magnetic sub-film is greater than 500 nm, when the first magnetic film or the second magnetic film is fixed, a proportion of the thickness of the insulating sub-films in the thickness of the first magnetic film or the second magnetic film decreases, so that the sub-eddy currents in the magnetic sub-films easily pass through the insulating sub-films and converge, thereby reducing an effect of loss of the eddy current. In addition, when the thickness t of the magnetic sub-film is greater than 500 nm, and a switch frequency in a circuit is a high frequency, an impedance of an eddy current path of the thin film inductor decreases. This does not facilitate limiting each sub-eddy current to a long and narrow loop of the magnetic sub-film.

Optionally, because the second magnetic film covers the upper support layer with a relatively large thickness, when the first magnetic film and the second magnetic film are anisotropic, a length of the first magnetic film is less than a length of the second magnetic film in a direction of a hard axis of the thin film inductor.

Optionally, the conductor is at least one metal conducting wire. The thin film inductor includes at least two magnetic cores. Two adjacent magnetic cores are spaced along a length direction of the metal conducting wire. The two adjacent magnetic cores are spaced, to reduce loss of the eddy current of the thin film inductor in the length direction of the metal conducting wire.

Optionally, the conductor is a coil. In addition, the thin film inductor includes a first magnetic core and a second magnetic core. The coil includes a plurality of first line segments and a plurality of second line segments. The first line segments are disposed opposite to the second line segments. The plurality of first line segments are located in the first magnetic core. The plurality of second line segments are located in the second magnetic core.

According to a second aspect, an integrated circuit is provided, including a silicon substrate and any thin film inductor described above. The thin film inductor is located on a silicon substrate. The integrated circuit has technical effects the same as the thin film inductor provided in the foregoing embodiment. Details are not described herein again.

Optionally, the integrated circuit further includes a circuit structure disposed on the silicon substrate, a circuit-inductor interconnection layer sequentially covering the circuit structure, and a chip encapsulation structure. The thin film inductor is located between the circuit-inductor interconnection layer and the chip encapsulation structure. The circuit-inductor interconnection layer is configured to electrically connect the thin film inductor to the circuit structure. A first magnetic film in the thin film inductor is closer to the silicon substrate than a second magnetic film. Alternatively, a second magnetic film in the thin film inductor is closer to the silicon substrate than a first magnetic film. Signal interconnection can be implemented between the thin film inductor and the circuit structure by using the circuit-inductor interconnection layer.

According to a third aspect, a terminal device is provided, including at least one integrated circuit described above. The mobile terminal further includes a power management chip and a power bus connected to the power management chip, where the power management chip includes an integrated circuit; and/or the mobile terminal further includes a processor and a data bus connected to the processor, where the processor includes an integrated circuit. The mobile terminal has technical effects the same as the integrated circuit provided in the foregoing embodiment. Details are not described herein again.

According to a fourth aspect, a method for preparing a thin film inductor is provided. The method includes the following: First, a first magnetic film is formed on a substrate by using a composition process. The first magnetic film is a trapezoidal frustum. An upper base of the trapezoidal frustum is away from the substrate, and a lower base is close to the substrate. The first magnetic film includes magnetic sub-films and insulating sub-films that are alternately disposed. The magnetic sub-films and the insulating sub-films in the first magnetic film are exposed from side surfaces of the trapezoid frustum. Next, a first dielectric layer is deposited on the substrate on which the first magnetic film is formed. Then, a flattening process is performed on the first dielectric layer, and a magnetic flux hole is prepared on the first dielectric layer by using the composition process. The first dielectric layer formed by using the composition process covers the upper base of the trapezoidal frustum and a part of the side surfaces of the trapezoidal frustum. Afterwards, a second dielectric layer is deposited on the substrate on which the foregoing structures are formed. The second dielectric layer covers an upper surface of the first dielectric layer and a sidewall of the magnetic flux hole, and is in contact with the other part of the side surfaces of the trapezoidal frustum by using the magnetic flux hole. Apart that is of the second dielectric layer and that is in contact with the side surfaces of the trapezoidal frustum serves as an insulating isolation film. On the substrate on which the insulating isolation film is formed, a conductor is formed above the upper base of the trapezoid frustum by using the composition process. On the substrate on which the conductor is formed, a second magnetic film is formed by using the composition process. The second magnetic film includes magnetic sub-films and insulating sub-films that are alternately disposed. An accommodation cavity for accommodating the conductor is formed between the first magnetic film and the second magnetic film. The method for preparing a thin film inductor has technical effects the same as the thin film inductor provided in the foregoing embodiment. Details are not described herein again.

### BRIEF DESCRIPTION OF DRAWINGS

FIG. 1 is a schematic structural diagram of a buck circuit in the current technology;
FIG. 2 is a schematic sectional structural diagram of a thin film inductor according to some embodiments of this application;
FIG. 3 is a schematic 3D structural diagram of a thin film inductor according to some embodiments of this application;
FIG. 4 is a schematic 3D structural diagram of another thin film inductor according to some embodiments of this application;
FIG. 5 is a schematic 3D structural diagram of another thin film inductor according to some embodiments of this application;
FIG. 6 is a schematic diagram of specific structures of a first magnetic film and a second magnetic film in FIG. 2;
FIG. 7a is a schematic diagram of a direction of magnetic lines in an alternating magnetic field according to some embodiments of this application;
FIG. 7b is another schematic diagram of a direction of magnetic lines in an alternating magnetic field according to some embodiments of this application;
FIG. 8 is a schematic diagram in which a longitudinal eddy current generated from magnetic lines in a horizontal direction in FIG. 7a or FIG. 7b is separated;
FIG. 9 is a schematic diagram of a lateral eddy current generated from magnetic lines in a vertical direction in FIG. 7a or FIG. 7b;
FIG. 10 is a schematic structural diagram of magnetic sub-films and insulating sub-films exposed from a surface that is of a first magnetic film and that is in contact with an insulating isolation film and/or a surface that is of a second magnetic film and that is in contact with the insulating isolation film in a thin film inductor according to some embodiments of this application;
FIG. 11a is a schematic structural diagram of a thin film inductor according to some embodiments of this application;
FIG. 11b is a schematic 3D structural diagram of a first magnetic film in FIG. 11a;
FIG. 11c is a schematic structural diagram of other components in the thin film inductor shown in FIG. 11a;
FIG. 11d is a schematic structural diagram of another thin film inductor according to some embodiments of this application;
FIG. 12 is a schematic structural diagram of another thin film inductor according to some embodiments of this application;
FIG. 13 is a schematic diagram of a partial structure of a first magnetic film in FIG. 11a;
FIG. 14 is a schematic diagram of separation of an eddy current in FIG. 13;
FIG. 15 is a schematic diagram of a partial structure of a thin film inductor according to some embodiments of this application;
FIG. 16a is a schematic diagram of a partial structure of another thin film inductor according to some embodiments of this application;
FIG. 16b is a schematic diagram of a partial structure of a second magnetic film in FIG. 16a;
FIG. 16c is a schematic diagram of separation of an eddy current in FIG. 16b;
FIG. 17 is a schematic diagram of a partial structure of another thin film inductor according to some embodiments of this application;
FIG. 18 is a schematic diagram of a partial structure of a first magnetic film in FIG. 17;
FIG. 19 is a schematic structural diagram of another thin film inductor according to some embodiments of this application;
FIG. 20 is a schematic diagram of a partial structure of a first magnetic film in FIG. 18;
FIG. 21 is a schematic structural diagram of an integrated circuit according to some embodiments of this application;
FIG. 22 is a schematic diagram of an inner structure of a terminal device according to some embodiments of this application;
FIG. 23 is a flowchart of a method for preparing a thin film inductor according to some embodiments of this application;
FIG. 24a, FIG. 24b, FIG. 24c, FIG. 24d, and FIG. 24e are schematic diagrams of a technological process of preparing a first magnetic film;
FIG. 25a, FIG. 25b, FIG. 25c, FIG. 25d, FIG. 25e, and FIG. 25f are schematic diagrams of a technological process of preparing a flattened dielectric layer having a magnetic flux hole;
FIG. 26 is a schematic diagram of a technological process of preparing an insulating isolation film;
FIG. 27a, FIG. 27b, FIG. 27c, and FIG. 27d are schematic diagrams of a technological process of preparing a conductor;
FIG. 28a, FIG. 28b, FIG. 28c, FIG. 28d, FIG. 28e, and FIG. 28f are schematic diagrams of a technological process of preparing an upper support layer and a second magnetic film;
FIG. 29a, FIG. 29b, FIG. 29c, FIG. 29d, and FIG. 29e are schematic diagrams of another technological process of preparing a flattened dielectric layer and an insulating isolation film;
FIG. 30a, FIG. 30b, FIG. 30c, and FIG. 30d are schematic diagrams of another technological process of preparing a conductor;
FIG. 31a, FIG. 31b, FIG. 31c, FIG. 31d, FIG. 31e, and FIG. 31f are schematic diagrams of another technological process of preparing an upper support layer and a second magnetic film;
FIG. 32 is a flowchart of another method for preparing a thin film inductor according to some embodiments of this application; and
FIG. 33a, FIG. 33b, FIG. 33c, FIG. 33d, FIG. 33e, and FIG. 33f are schematic diagrams of a process corresponding to some steps for preparing a thin film inductor in FIG. 32.

### Reference numerals:

01: film inductor; 02: integrated circuit; 03: terminal device; 10: magnetic core; 101: first magnetic film; 120: magnetic sub-film; 121: insulating sub-film; 102: second magnetic film; 20: conductor; 201: first line segment; 202: second line segment; 30: insulating isolation film; 40: support pad; 21: accommodation cavity; 22: flattened dielectric layer; 23: magnetic flux hole; 24: interlayer dielectric layer; 25: tail of a second magnetic film; 26: lower support layer; 27: seed layer; 28: upper support layer; 29: adhesion layer; 50: silicon substrate; 51: circuit structure; 501: transistor; 502: metal interconnection layer; 52: circuit-inductor interconnection layer; 53: chip encapsulation structure; 54: chip encapsulation pin; 60: power management chip; 61: processor; 70: photoresist; 71: mask reticle; 80: first dielectric layer; 81: second dielectric layer.

### DESCRIPTION OF EMBODIMENTS

The following describes the technical solutions in the embodiments of this application with reference to the accompanying drawings in the embodiments of this application. Clearly, the described embodiments are merely a part rather than all of the embodiments of this application.

The following terms "first" and "second" are merely intended for a purpose of description, and shall not be understood as an indication or implication of relative importance or implicit indication of the number of indicated technical features. Therefore, a feature limited by "first" or "second" may explicitly or implicitly include one or more features.

In addition, in this application, position terms such as "top" and "bottom" are defined relative to positions of components in the accompanying drawings. It should be understood that these position terms are relative concepts used for relative description and clarification, and may correspondingly change according to changes in the positions of the components in the accompanying drawings.

An embodiment of this application provides an integrated circuit. An example in which the integrated circuit is a voltage conversion circuit is used. When a switch frequency of a switch transistor in the voltage conversion circuit is improved, for example, the switch frequency of the switch transistor is increased to 40 MHz to 200 MHz, an inductor with a very small inductance may be selected in the circuit, to reduce a ripple of a current output from the voltage conversion circuit.

In this case, an area of the inductor is small, thereby resolving a problem of a relatively large size of an inductor in an electronic product.

On this basis, the inductor may be integrated into a silicon substrate of the integrated circuit, and the inductor is prepared at a position near a ball grid array (BGA) of a power supply in the integrated circuit, to form an integrated voltage regulator (IVR) circuit. In this way, a power supply path of the power supply can be shortened, and an impedance of a power delivery network (power delivery network, PDN) of the power supply in a circuit with a high-frequency switch can be reduced.

On this basis, to integrate an inductor with an inductance of 5 nH to 10 nH into the integrated circuit, the integrated circuit provided in this embodiment of this application includes a thin film inductor.

As shown in FIG. 2, the thin film inductor 01 includes at least one magnetic core 10 and a conductor 20 located in each magnetic core 10.

Each magnetic core 10 includes a first magnetic film 101 and a second magnetic film 102 that are disposed opposite to each other.

The second magnetic film 102 and the first magnetic film 101 are made of a magnetic material. To increase an inductance per unit area of the thin film inductor, a magnetic material with a relatively high magnetic permeability and a relatively good saturation characteristic may be used, for example, a magnetic alloy material such as FeNi, CoZrTa, CoZrTaB, CZTB, FeCoB, FeHfO, or CoFeHfO alloy.

In addition, an accommodation cavity 21 exists between the first magnetic film 101 and the second magnetic film 102. The conductor 20 is located in the accommodation cavity 21.

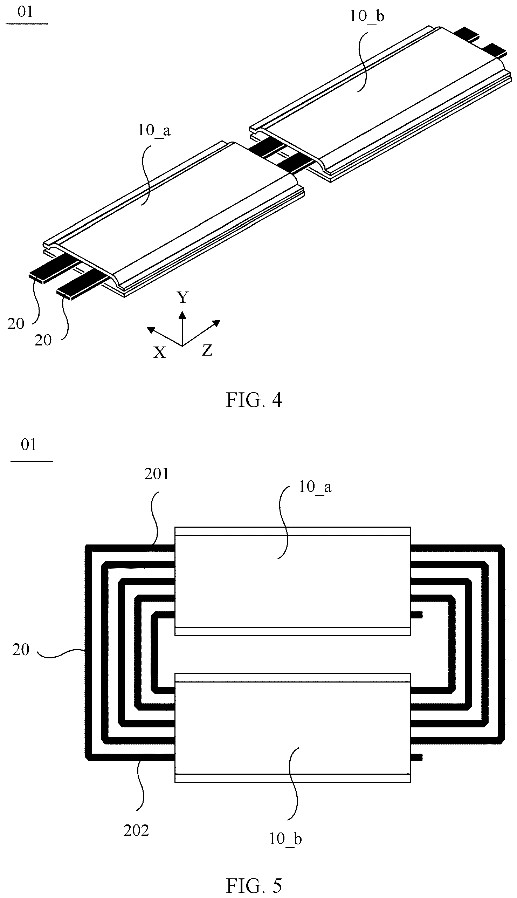

In some embodiments of this application, as shown in FIG. 3 or FIG. 4, the conductor 20 may be at least one metal conducting wire.

In this case, to reduce loss of an eddy current of the thin film inductor 01 in a length direction (Z direction) of the metal conducting wire, the thin film inductor 01 may include at least two magnetic cores, for example, a first magnetic core 10_a and a second magnetic core 10_b. In addition, the two adjacent magnetic cores, that is, the first magnetic core 10_a and the second magnetic core 10_b are spaced and insulated in the length direction (Z direction) of the metal conducting wire.

In this case, the first magnetic film 101 and the second magnetic film 102 may be anisotropic. In this case, the length direction (Z direction) of the metal conducting wire is an easy axis (easy axis) of a magnetic field of the first magnetic film 101 and the second magnetic film 102.

In addition, when a switch frequency in a circuit in which the thin film inductor 01 is located is greater than 40 MHz, a width direction (X direction) of the metal conducting wire is a hard axis (hard axis) of the magnetic field of the first magnetic film 101 and the second magnetic film 102.

It should be noted that two metal conducting wires are disposed in the same magnetic core 10 in FIG. 4. A magnetic flux generated by one metal conducting wire is coupled to a magnetic flux generated by the other metal conducting wire. In this case, the thin film inductor 01 may be a coupling inductor. To implement that the thin film inductor 01 including the two metal conducting wires is the foregoing coupling inductor, the two metal conducting wires need to be separately driven by using two independent circuits.

Alternatively, in other embodiments of this application, as shown in FIG. 5, the conductor 20 is a coil. In addition, the thin film inductor includes a first magnetic core 10_a and a second magnetic core 10_b.

The coil includes a plurality of first line segments 201 and a plurality of line segments 202. The first line segments 201 are disposed opposite to the second line segments 202. As shown in FIG. 5, the plurality of first line segments 201 are an upper part of the coil, and the plurality of second line segments 202 are a lower part of the coil.

In this case, the plurality of first line segments 201 are located in the first magnetic core 10_a, and the plurality of second line segments 202 are located in the second magnetic core 10_b.

It should be noted that this application does not limit a quantity of turns of the coil obtained through winding the conducting wire 20. For the thin film inductor 01 shown in FIG. 5, the quantity of turns of the coil obtained through winding the conducting wire 20 may be designed based on an inductance required by the thin film inductor 01.

A larger quantity of turns of the coil indicates a larger inductance of the thin film inductor 01, and a smaller quantity of turns of the coil indicates a smaller inductance of the thin film inductor 01.

In addition, the thin film inductor 01 is applied to a power delivery circuit of a power supply. When the power delivery circuit of the power supply supplies a small current, an inductance of the thin film inductor 01 needs to be set relatively large. When the power delivery circuit of the power supply supplies a large current, an inductance of the thin film inductor 01 needs to be set relatively small. On this basis, as shown in FIG. 2, the film inductor 01 further includes an insulating isolation film 30. The insulating isolation film 30 is disposed on two sides of the conductor 20, and is located in a gap (gap) between the first magnetic film 101 and the second magnetic film 102. A lower surface and an upper surface of the insulating isolation film 30 are respectively in contact with the first magnetic film 101 and the second magnetic film 102.

It should be noted that the two sides of the conductor 20 indicate two sides of the conductor 20 in a signal transmission direction (for example, the Z direction in FIG. 3).

The insulating isolation film 30 separates the first magnetic film 101 from the second magnetic film 102, to prevent the first magnetic film 101 from being electrically connected to the second magnetic film 102. In addition, a thickness of the insulating isolation film 30 is thin. For example, the thickness may be about 0.5 µm. Therefore, a magnetic line in the first magnetic film 101 can enter the second magnetic film 102 through the insulating isolation film 30, or a magnetic line in the second magnetic film 102 can enter the first magnetic film 101 through the insulating isolation film 30.

It may be learned from the foregoing that, to increase the inductance per unit area of the thin film inductor 01, a magnetic material with a relatively high magnetic permeability and a relatively good saturation characteristic may be used to form the first magnetic film 101 and the second magnetic film 102. However, in this case, a resistivity of the thin film inductor 01 is relatively small. When a switch frequency of a switch transistor in a voltage conversion circuit is relatively high, relatively large loss may occur to an eddy current generated in the thin film inductor 01. In this way, the inductance of the thin film inductor 01 is reduced. In addition, the relatively large loss of the eddy current causes heat emitting of the thin film inductor 01, thereby reducing an inductance value Q and reducing conversion efficiency of the voltage conversion circuit.

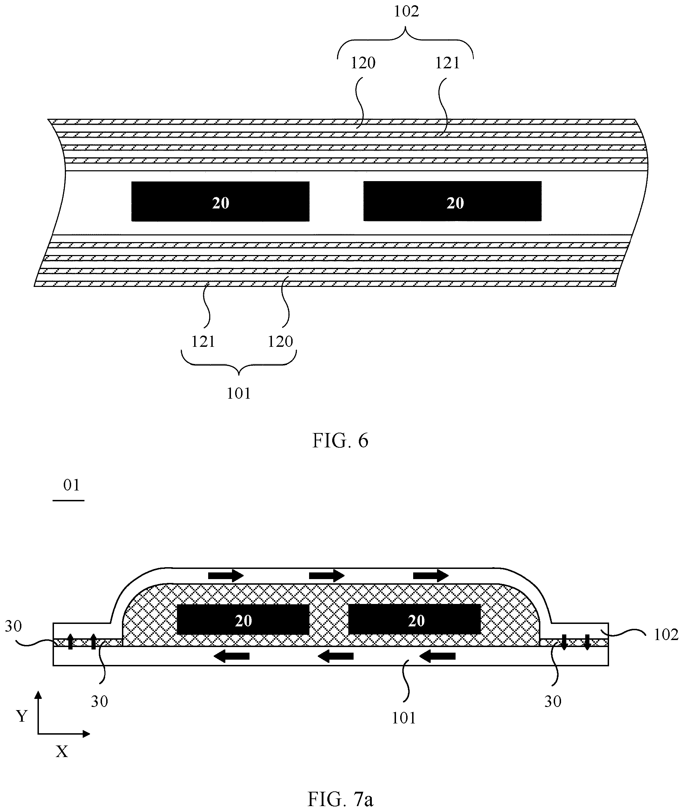

To resolve the foregoing problem, as shown in FIG. 6, the first magnetic film 101 and the second magnetic film 102 each include magnetic sub-films 120 and insulating sub-films 121.

In the first magnetic film 101, the magnetic sub-films 120 and the insulating sub-films 121 are alternately disposed. In the second magnetic film 102, the magnetic sub-films 120 and the insulating sub-films 121 are alternately disposed.

In this case, the first magnetic film 101 and the second magnetic film 102 are in a structure of a plurality of laminated (laminated) layers of thin films.

In this case, after the conductor 20 in the thin film inductor 01 is powered on, as shown in FIG. 7a, a direction of magnetic lines (indicated by using black arrows in the figure) of an alternating magnetic field generated by the thin film inductor 01 may be clockwise.

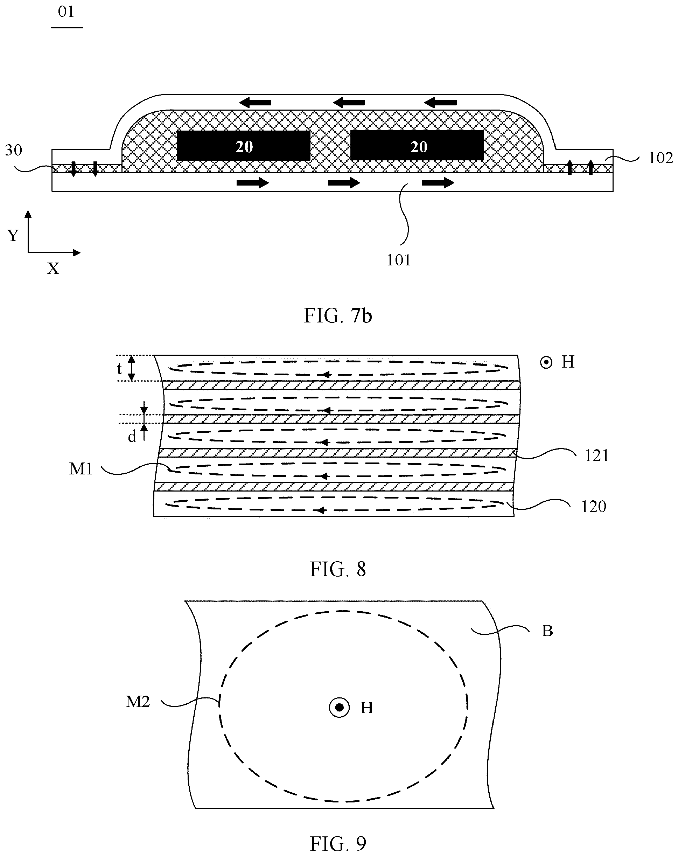

Alternatively, after a direction of a current flowing into the conductor 20 is changed, as shown in FIG. 7b, a direction of magnetic lines of an alternating magnetic field generated by the thin film inductor 01 is counterclockwise.

In the first magnetic film 101 and the second magnetic film 102, a closed loop current, that is, the eddy current is induced in the alternating magnetic field at a section perpendicular to the direction of the magnetic lines. Generation of the eddy current causes additional loss, thereby weakening the magnetic field.

On this basis, in FIG. 7a and FIG. 7b, in the first magnetic film 101 and the second magnetic film 102, a loop current is induced in the alternating magnetic field at a section perpendicular to horizontal (X direction) magnetic lines. The loop current is a longitudinal eddy current.

It may be learned from the foregoing that because the first magnetic film 101 and the second magnetic film 102 include the insulating magnetic sub-films 120. Therefore, as shown in FIG. 8, the longitudinal eddy current formed at the section perpendicular to the X direction is separated into a plurality of sub-eddies M1 by the layers of magnetic sub-films 120 in the first magnetic film 101 and the second magnetic film 102. Each sub-eddy current M1 is limited to a long and narrow loop of each magnetic sub-film 120. In this way, a resistance on a path of the eddy current is increased, to reduce loss of the eddy current.

It should be noted that a magnetic field generated by the eddy current is a change to an original magnetic field generated when the first magnetic film 101 and the second magnetic film 102 are powered on.

For example, as shown in FIG. 8, a direction H of the original magnetic field generated when the first magnetic film 101 and the second magnetic film 102 are powered on is from inside to outside, and a direction of the eddy current is clockwise during the original magnetic field is being enhanced.

Alternatively, a direction H of the original magnetic field generated when the first magnetic film 101 and the second magnetic film 102 are powered on is from inside to outside, and a direction of the eddy current is counterclockwise during the magnetic field is being weakened.

In addition, when the switch frequency in the circuit is a low frequency, each sub-eddy current M1 is easily limited to each layer of magnetic sub-film 120. However, when the switch frequency in the circuit is a high frequency, because a capacitance effect exists between the layers of magnetic sub-films 120, that is, a higher frequency indicates a smaller impedance of a capacitor, the sub-eddy currents M1 in the magnetic sub-films 120 more easily pass through the insulating sub-films 121 and converge, to form a large eddy current path. In this way, an effect of the loss of the eddy current is reduced.

In this case, when the switch frequency in the circuit is a high frequency, to increase the impedance of the capacitor, a thickness of the insulating sub-film 121 may be appropriately increased.

For example, a thickness d of each layer of insulating sub-film 121 may be from 5 nm to 50 nm. When the thickness d of the insulating sub-film 121 is less than 5 nm, and the switch frequency in the circuit is a high frequency, the impedance of the capacitor formed between the layers of magnetic sub-films 120 is relatively small, so that sub-eddy currents M1 in the magnetic sub-films 120 easily pass through the insulating sub-films 121 and converge, to reduce the effect of the loss of the eddy current.

In addition, when the thickness d of the insulating sub-film 121 is greater than 50 nm, if the first magnetic film 101 or the second magnetic film 102 is fixed, a proportion of a thickness of the magnetic sub-films 120 in a thickness of the first magnetic film 101 or the second magnetic film 102 decreases, thereby reducing an effective magnetic permeability of the thin film inductor 01.

In some embodiments of this application, the thickness d of the insulating sub-film 121 may be 5 nm, 10 nm, 15 nm, 25 nm, or 50 nm.

The insulating sub-film 121 is made of an insulating inorganic or organic material.

In addition, a thickness t of each layer of magnetic sub-film 120 may be from 100 nm to 500 nm. When the thickness t of the magnetic sub-film 120 is less than 100 nm, the thickness t of the magnetic sub-film 120 is quite small. This does not facilitate improving the effective magnetic permeability of the thin film inductor 01.

When the thickness t of the magnetic sub-film 120 is greater than 500 nm, if the first magnetic film 101 or the second magnetic film 102 is fixed, a proportion of the thickness of the insulating sub-films 121 in the thickness of the first magnetic film 101 or the second magnetic film 102 decreases, so that the sub-eddy currents M1 in the magnetic sub-films 120 easily pass through the insulating sub-films 121 and converge, thereby reducing the effect of the loss of the eddy current. In addition, when the thickness t of the magnetic sub-film 120 is greater than 500 nm, and the switch frequency in the circuit is a high frequency, an impedance of an eddy current path of the thin film inductor 01 decreases. This does not facilitate limiting each sub-eddy current M1 to a long and narrow loop of the magnetic sub-film 120.

In some embodiments of this application, the thickness t of the magnetic sub-film 120 may be 100 nm, 150 nm, 180 nm, 250 nm, 300 nm, 350 nm, 400 nm, 450 nm, or 500 nm.

The magnetic sub-film 120 is made of the foregoing magnetic material.

In addition, as shown in FIG. 7a or FIG. 7b, at the insulating isolation film 30 of the thin film inductor 01, the magnetic lines are perpendicular to a magnetic film surface of the first magnetic film 101. In this case, in the first magnetic film 101 or the second magnetic film 102, a closed loop current is induced in the alternating magnetic field at a section perpendicular to a direction (Y direction) of a vertical magnetic line. The loop current is a lateral eddy current M2 that is shown in FIG. 9 and that is parallel to a film surface B of the first magnetic film 101.

As described above, a direction of the eddy current in FIG. 9 is related to the original magnetic field generated when the first magnetic film 101 and the second magnetic film 102 are powered on. Details are not described herein.

A plane in which the lateral eddy current M2 is located is parallel to the magnetic sub-films 120 in the first magnetic film 101 or the second magnetic film 102. Therefore, the lateral eddy current M2 cannot be separated by the plurality of layers magnetic sub-films 120. In this case, loss of the eddy current at a position of the insulating isolation film 30 cannot be effectively reduced.

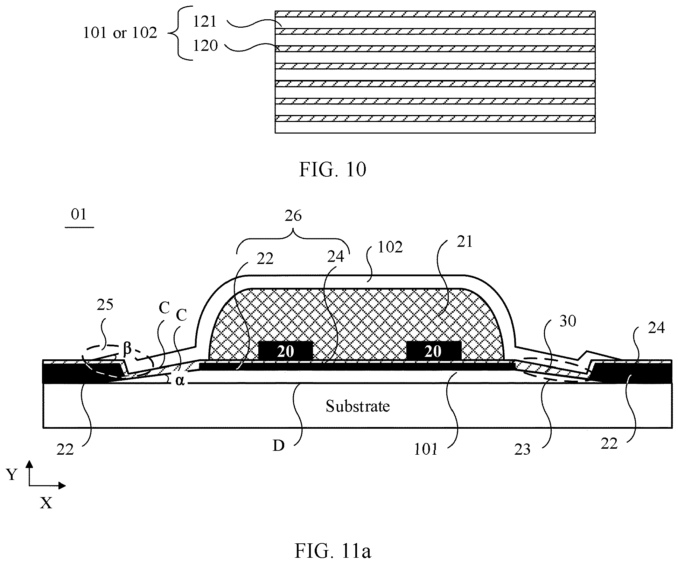

To resolve the foregoing problem, in the thin film inductor 01 provided in this embodiment of this application, as shown in FIG. 10, the magnetic sub-films 120 and the insulating sub-films 121 in the first magnetic film 101 are exposed from a surface that is of the first magnetic film 101 and that is in contact with the insulating isolation film 30, and/or, the magnetic sub-films 120 and the insulating sub-films 121 in the second magnetic film 102 are exposed from a surface that is of the second magnetic film 102 and that is in contact with the insulating isolation film 30.

In this case, the magnetic sub-films 120 and the insulating sub-films 121 that are exposed from the surface that is of the first magnetic film 101 and that is in contact with the insulating isolation film 30 and/or the surface that is of the second magnetic film 102 and that is in contact with the insulating isolation film 30 intersect a plane in which an eddy current generated from magnetic lines passing through the insulating isolation film 30.

In this way, the magnetic lines passing through the insulating isolation film 30 can enter the first magnetic film 101 and/or the magnetic sub-films 120 exposed from the surface in contact with the insulating isolation film 30. In this case, the eddy current generated in the plane perpendicular to the magnetic lines is separated into the plurality of sub-eddy currents by the layers of magnetic sub-films 120. As shown in FIG. 8, each sub-eddy current enters one layer of magnetic sub-film 120. In this case, each sub-eddy current can be limited to one layer of magnetic sub-film 120, to reduce loss of the eddy current.

In the following, a structure of the magnetic core 10 can be described by using an example. In the structure of the magnetic core 10, the magnetic sub-films 120 intersect the plane in which the eddy current generated from the magnetic lines passing through the insulating isolation film 30 is located.

### Example 1

In this example, as shown in FIG. 11a, the surface that is of the first magnetic film 101 and that is in contact with the insulating isolation film 30 and the surface that is of the second magnetic film 102 and that is in contact with the insulating isolation film 30 are inclined surfaces C with a same slope. In this case, a thickness of the insulating isolation film 30 is the same at all positions.

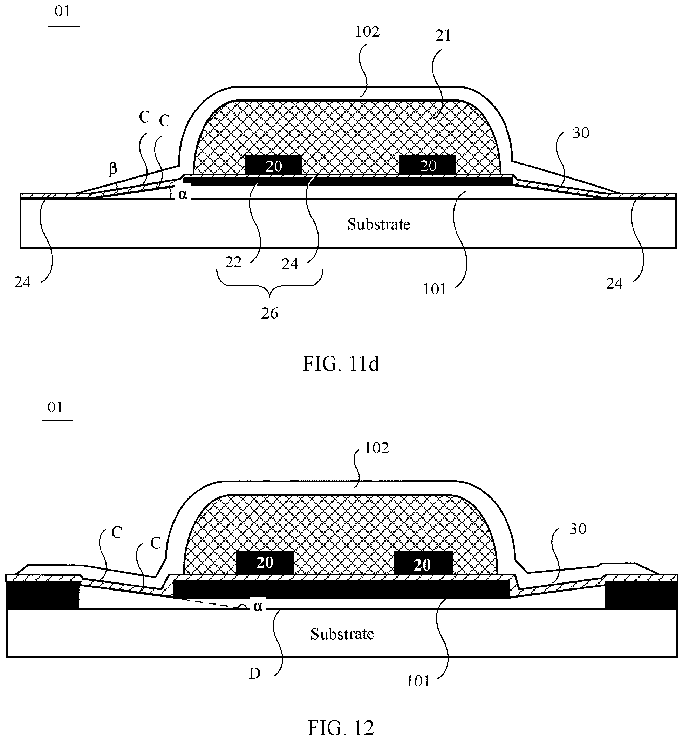

There is an included angle α between the inclined surface C and a lower surface D of the first magnetic film 101. The included angle α may be an acute angle shown in FIG. 11a. Alternatively, as shown in FIG. 12, the included angle α is an obtuse angle. This is not limited in this application.

It should be noted that the lower surface D of the first magnetic film 101 is a surface that is of the first magnetic film 101 and that is away from the second magnetic film 102.

It may be learned from FIG. 11a and FIG. 12 that when the included angle α is an acute angle, an average thickness of the first magnetic film 101 is thinner, to facilitate implementing an ultra-thin design requirement of an electronic element. For ease of description, the following is described by using an example in which the included angle α is an acute angle.

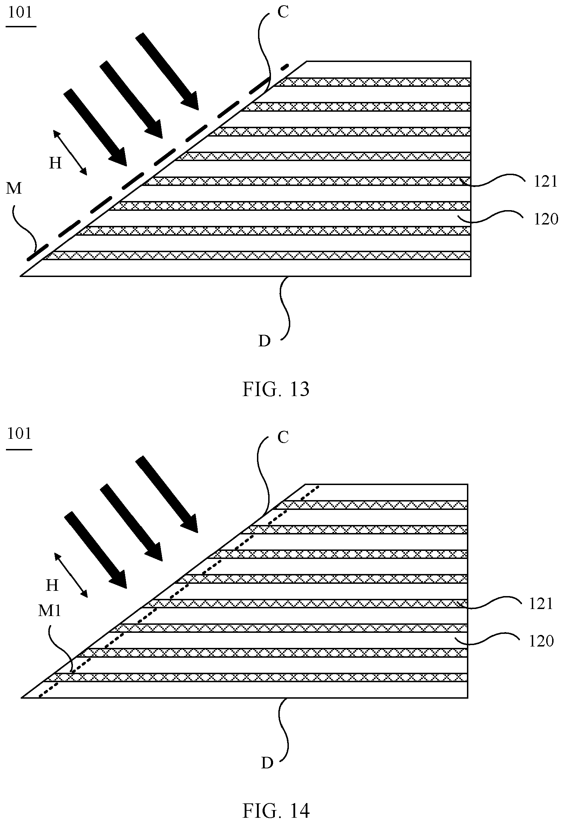

In addition, as shown in FIG. 13, the magnetic sub-films 120 and the insulating sub-films 121 in the first magnetic film 101 are parallel to the lower surface D of the first magnetic film 101.

In this case, in a process of preparing the first magnetic film 101, first, a physical vapor deposition (Physical Vapor Deposition, PVD) process is applied on a bearing surface of a substrate for a plurality of times to implement alternately sputtering, to form the magnetic sub-films 120 and insulating sub-films 121 that are alternately disposed, thereby finally forming the first magnetic film 101.

The magnetic sub-films 120 and the insulating sub-films 121 formed in the foregoing steps are parallel to the bearing surface of the substrate, so that the magnetic sub-films 120 and the insulating sub-films 121 in the first magnetic film 101 can be parallel to the lower surface D of the first magnetic film 101 (that is, the surface that is of the first magnetic film 101 and that is in contact with the bearing surface of the substrate).

In this way, the magnetic sub-films 120 and the insulating sub-films 121 in the first magnetic film 101 intersect the inclined surface C, so that the magnetic sub-films 120 and the insulating sub-films 121 in the first magnetic film 101 can be exposed from the inclined surface C.

In some embodiments of this application, the inclined surface C may be prepared by using a lift-off (lift-off) process. The lift-off process is described in detail in the following description.

Next, the insulating isolation film 30 and the conductor 20 are prepared. The magnetic sub-films 120 and the insulating sub-films 121 in the second magnetic film 102 are parallel to the lower surface D of the first magnetic film 101.

In addition, as shown in FIG. 11a, the inclined surface C may also be formed at the surface that is of the second magnetic film 102 and that is in contact with the insulating isolation film 30. In this way, the surface that is of the first magnetic film 101 and that is in contact with the insulating isolation film 30 and the surface that is of the second magnetic film 102 and that is in contact with the insulating isolation film 30 are the inclined surfaces C.

In the following, a specific structure of the thin film inductor 01 is described by using an example when the included angle α between the lower surface D of the first magnetic film 101 and each of the surface that is of the first magnetic film 101 and that is in contact with the insulating isolation film 30 and the surface that is of the second magnetic film 102 and that is in contact with the insulating isolation film 30 is an acute angle.

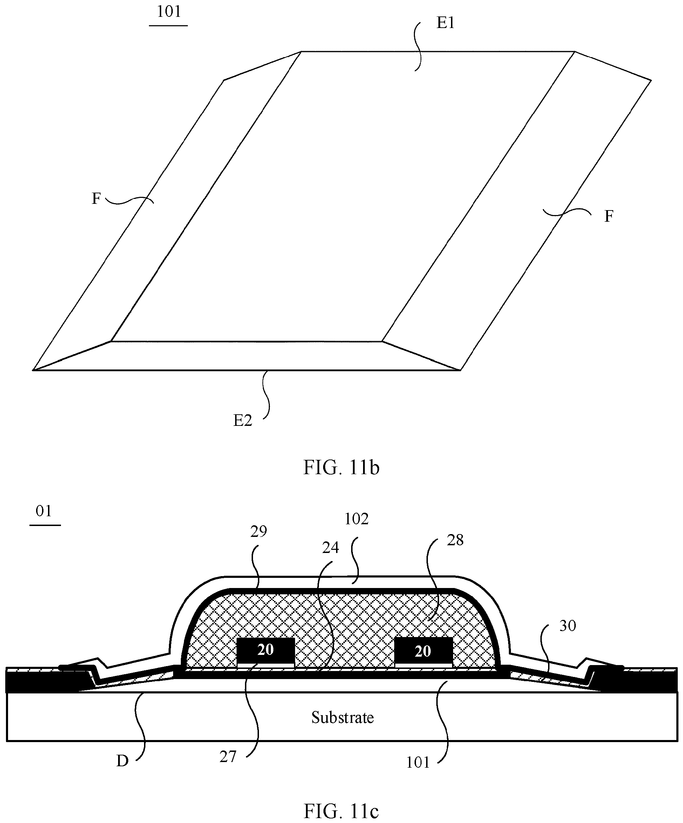

For example, the first magnetic film 101 shown in FIG. 11a may be a trapezoidal frustum shown in FIG. 11b.

An upper base E1 of the trapezoidal frustum is close to the second magnetic film 102, and a lower base E2 is away from the second magnetic film 102.

In addition, as shown in FIG. 11a, the thin film inductor 01 further includes a flattened dielectric layer 22, a magnetic flux hole 23, and an interlayer dielectric layer 24.

The flattened dielectric layer 22 covers the upper base of the trapezoidal frustum, that is, the first magnetic film 101, and a part of side surfaces F of the trapezoidal frustum.

In some embodiments of this application, when the flattened dielectric layer 22 is prepared, a dielectric layer may be first deposited on the substrate on which the first magnetic film 101 is prepared. A material of the dielectric layer may include at least one of Si₃N₄ or SiO₂. Then, a chemical mechanical planarization (Chemical Mechanical Planarization, CPM) process is used to grind an upper surface of the dielectric layer (a surface away from the first magnetic film 101), so that the surface of the dielectric layer is flat, to achieve a flattening purpose.

A part of the material of the flattened dielectric layer 22 is etched, to form the magnetic flux hole 23. The insulating isolation film 30 is located in the magnetic flux hole 23, and covers the other part of the side surfaces F of the trapezoidal frustum.

It may be learned from FIG. 11a that the part of the side surfaces F of the trapezoidal frustum, that is, the first magnetic film 101 is covered by the insulating isolation film 30, and the other part is covered by the flattened dielectric layer 22.

The interlayer dielectric layer 24 covers an upper surface of the flattened dielectric layer 22 and a sidewall of the magnetic flux hole 23.

The interlayer dielectric layer 24 and the insulating isolation film 30 are made of the same material. For example, the material may be at least one of Si₃N₄ or SiO₂. In addition, the interlayer dielectric layer 24 and the insulating isolation film 30 may be an integrated structure.

In this case, a dielectric layer may be deposited by using the same deposition process on the substrate on which the flattened dielectric layer 22 and the magnetic flux hole 23 are prepared. In this case, a part that is of the dielectric layer, that is located in the magnetic flux hole 23, and that is in contact with the side surfaces of the trapezoidal frustum, that is, the first magnetic film 101 is the insulating isolation film 30. Apart that is of the dielectric layer and that covers the upper surface of the flattened dielectric layer 22 and the sidewall of the magnetic flux hole 23 is the interlayer dielectric layer 24.

On this basis, as shown in FIG. 11a, the flattened dielectric layer 22 and a part that is of the interlayer dielectric layer 24 and that covers the upper base E1 of the trapezoidal frustum, that is, the first magnetic film 101 serve as a lower support layer 26 for bearing the conductor 20. It may be learned from the foregoing that the lower support layer 26 is made of an inorganic material, for example, mainly Si₃N₄ and/or SiO₂.

In addition, as shown in FIG. 11a, a tail 25 of the second magnetic film 102 covers the sidewall on a side that is of the magnetic flux hole 23 and that is away from the accommodation cavity 21, and covers, after a turning, the upper surface of the interlayer dielectric layer 24 connected to the sidewall.

An end that is of the tail 25 of the second magnetic film 102 and that is away from the accommodation cavity 21 has a taper angle β.

The taper angle β is from 10° to 90°.

For example, in some embodiments of this disclosure, the taper angle β may be 12°, 15°, 19°, 20°, 30°, 60°, or 85°.

In addition, as shown in FIG. 11c, the thin film inductor 01 further includes a seed layer (Seed layer) 27, an upper support layer 28, and an adhesion layer (Adhesion layer) 29.

The seed layer 27 is located in the accommodation cavity 21. The seed layer 27 is in contact with a surface that is of the conductor 20 and that is close to the first magnetic film 101.

A material forming the seed layer 27 includes at least one of titanium (Ti) or copper (Cu). When the conductor 20 is prepared by using an electroplating process, the conductor 20 may be disposed on an upper surface of the lower support layer 26 by using the seed layer 27.

The upper support layer 28 is located in the accommodation cavity 21. The upper support layer 28 covers surfaces of the conductor 20 except the surface in contact with the seed layer 27.

A material forming the upper support layer 28 may be an organic macromolecular polymer (Polymer). In this way, the upper support layer 28 has a relatively large thickness relative to the lower support layer 26 (as shown in FIG. 11a), to support the second magnetic film 102. In addition, the thickness of the upper support layer 28 is adjusted to adjust a height of the entire thin film inductor 01.

On this basis, because of the relatively large thickness of the upper support layer 28, when the first magnetic film 101 and the second magnetic film 102 are anisotropic, a film length of the second magnetic film 102 covering the upper support layer 28 is greater than a film length of the first magnetic film 101 covering the substrate in the X direction (in FIG. 11a, the hard axis of the film inductor 01).

In addition, in this application, a film length of the second magnetic film 102 and a film length of the first magnetic film 101 are not limited in the Z direction (in FIG. 3, the easy axis of the film inductor 01). For example, the film length of the second magnetic film 102 may be greater than the film length of the first magnetic film 101. Alternatively, the film length of the second magnetic film 102 may be less than the film length of the first magnetic film 101.

In addition, the adhesion layer 29 is disposed on a surface that is of the second magnetic film 102 and that is close to the first magnetic film 101.

A material forming the adhesion layer 29 includes at least one of tantalum (Ta), titanium (Ti), titanium nitride (TiN), or tantalum nitride (TaN). The adhesion layer 29 is configured to bond the second magnetic film 102 to the upper support layer 28, a magnetic film air gap film layer 30, and the interlayer dielectric layer 24.

Alternatively, a specific structure of the thin film inductor 01 is shown in FIG. 11d when the included angle α between the lower surface D of the first magnetic film 101 and each of the surface that is of the first magnetic film 101 and that is in contact with the insulating isolation film 30 and the surface that is of the second magnetic film 102 and that is in contact with the insulating isolation film 30 is an acute angle. The first magnetic film 101 is the trapezoidal frustum shown in FIG 11b. The upper base E1 of the trapezoidal frustum is close to the second magnetic film 102, and the lower base E2 is away from the second magnetic film 102.

A difference between the structure shown in FIG. 11a and that shown in FIG. 11d is that the side surfaces F of the trapezoidal frustum are fully covered by the insulating isolation film 30.

In this case, the thin film inductor 01 shown in FIG. 11d further includes the flattened dielectric layer 22 and the interlayer dielectric layer 24.

The flattened dielectric layer 22 covers the upper base E1 of the trapezoidal frustum. A material of the flattened dielectric layer 22 is the same as that described above. Details are not described herein again.

In some embodiments of this application, when the flattened dielectric layer 22 shown in FIG. 11d is prepared, a dielectric layer may be first deposited on the substrate on which the first magnetic film 101 is prepared. A material of the dielectric layer may include Si₃N₄ and/or SiO₂.

Then, a chemical mechanical planarization (Chemical Mechanical Planarization, CPM) process is used to grind an upper surface of the dielectric layer (a surface away from the first magnetic film 101), so that the surface of the dielectric layer is flat, to achieve a flattening purpose.

Next, an etching process is used to remove a part of the dielectric layer except the part covering the upper base E1 of the trapezoid frustum, to obtain the flattened dielectric layer 22 shown in FIG. 11d.

In addition, the interlayer dielectric layer 24 covers the flattened dielectric layer 22. The interlayer dielectric layer 24 and the insulating isolation film 30 are made of the same material and are an integrated structure.

In this case, a dielectric layer may be deposited by using the same deposition process on the substrate on which the flattened dielectric layer 22 is prepared. In this case, a part that is of the dielectric layer and that covers the side surfaces of the trapezoid frustum, that is, the first magnetic film 101 serves as the insulating isolation film 30. The remaining part of the dielectric layer is the interlayer dielectric layer 24.

On this basis, as shown in FIG. 11d, the flattened dielectric layer 22 and the part that is of the interlayer dielectric layer 24 and that covers the upper base E1 of the trapezoidal frustum, that is, the first magnetic film 101 serve as the lower support layer 26 for bearing the conductor 20. It may be learned from the foregoing that the lower support layer 26 is made of an inorganic material, for example, mainly Si₃N₄ and/or SiO₂.

In addition, an end that is away from the accommodation cavity 21 and that is of a part that is of the second magnetic film 102 and that is in contact with the insulating isolation film 30 has a taper angle β. The taper angle β is from 10° to 90°. For example, in some embodiments of this disclosure, the taper angle β may be 12°, 15°, 19°, 20°, 30°, 60°, or 85°.

It should be noted that the thin film inductor 01 shown in FIG. 11d also has the seed layer 27, the upper support layer 28, and the adhesion layer 29. A manner of setting these thin film layers is the same as that described above. Details are not described herein again.

The following uses the structure shown in FIG. 11a as an example to describe a process in which the inclined surfaces C can be used to reduce loss of the eddy current at the insulating isolation film 30 in the thin film inductor 01 when the surface that is of the first magnetic film 101 and that is in contact with the insulating isolation film 30 and the surface that is of the second magnetic film 102 and that is in contact with the insulating isolation film 30 are the inclined planes C.

In the following description, after the conductor 20 in the thin film inductor 01 is powered on, when the direction of the magnetic lines of the alternating magnetic field generated by the thin film inductor 01 is counterclockwise shown in FIG. 7b, the first magnetic film 101 in contact with the left-side insulating isolation film 30 in FIG. 7b or FIG. 11a serves as an example.

In this case, as shown in FIG. 13, the magnetic lines passing through the insulating isolation film 30 are perpendicular to the surface that is of the first magnetic film 101 and that is in contact with the insulating isolation film 30, that is, the inclined surface C shown in FIG. 13. In this case, the eddy current M is induced in the alternating magnetic field at the section perpendicular to the direction of the magnetic lines, that is, the section parallel to the inclined surface C.

In addition, because the magnetic sub-films 120 and the insulating sub-films 121 in the first magnetic film 101 are parallel to the lower surface D of the first magnetic film 101, as shown in FIG. 10, the magnetic sub-films 120 and the insulating sub-films 121 in the first magnetic film 101 can be exposed from the surface that is of the first magnetic film 101 and that is in contact with the insulating isolation film 30, that is, the inclined surface C shown in FIG. 13. In this case, the magnetic lines passing through the insulating isolation film 30 can enter the magnetic sub-films 120 in the first magnetic film 101 shown in FIG. 14.

In this way, as shown in FIG. 14, the eddy current M is separated into the plurality of sub-eddy currents M1 by the layers of magnetic sub-films 120. In addition, each sub-eddy current M1 enters one layer of magnetic sub-film 120. In this case, as shown in FIG. 8, each sub-eddy current M1 can be limited to each layer of magnetic sub-film 120, to reduce loss of the eddy current.

### Example 2

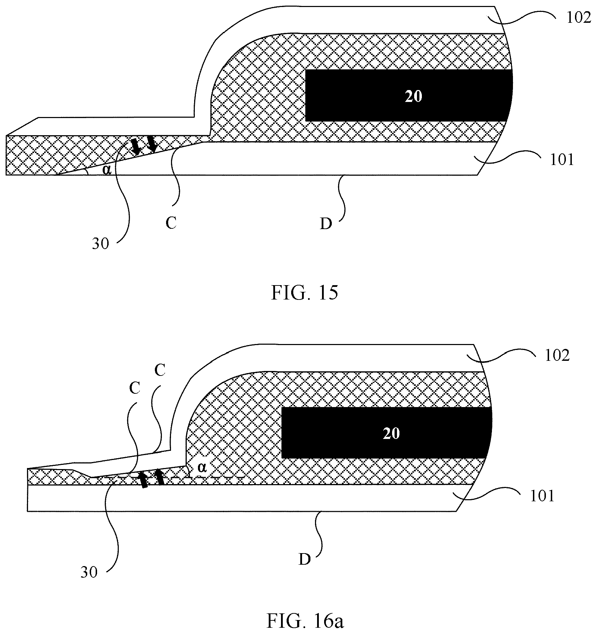

In this example, as shown in FIG. 15, in the magnetic core 10, only the surface that is of the first magnetic film 101 and that is in contact with the insulating isolation film 30 is the inclined surface C.

On this basis, after the conductor 20 in the thin film inductor 01 is powered on, when the direction of the magnetic lines of the alternating magnetic field generated by the thin film inductor 01 is counterclockwise shown in FIG. 7b, the first magnetic film 101 in contact with the left-side insulating isolation film 30 in FIG. 7b is used as an example.

The magnetic lines passing through the insulating isolation film 30 are perpendicular to the surface that is of the first magnetic film 101 and that is in contact with the insulating isolation film 30, that is, the inclined surface C shown in FIG. 13, so that the magnetic lines can enter the magnetic sub-films 120 in the first magnetic film 101. This is the same as Example 1. In this case, the eddy current M is induced in the alternating magnetic field at the section perpendicular to the direction of the magnetic lines, that is, the section parallel to the inclined surface C.

In addition, as shown in FIG. 14, the eddy current M is separated into the plurality of sub-eddy currents M1 by the layers of magnetic sub-films 120. In addition, each sub-eddy current M1 enters one layer of magnetic sub-film 120. In this case, as shown in FIG. 8, each sub-eddy current M1 can be limited to each layer of magnetic sub-film 120, to reduce loss of the eddy current.

### Example 3

In this example, as shown in FIG. 16a, in the magnetic core 10, only the surface that is of the second magnetic film 102 and that is in contact with the insulating isolation film 30 is the inclined surface C.

In this case, after the conductor 20 in the thin film inductor 01 is powered on, when the direction of the magnetic lines of the alternating magnetic field generated by the thin film inductor 01 is clockwise shown in FIG. 7a, the second magnetic film 102 in contact with the left-side insulating isolation film 30 in FIG. 7a is used as an example.

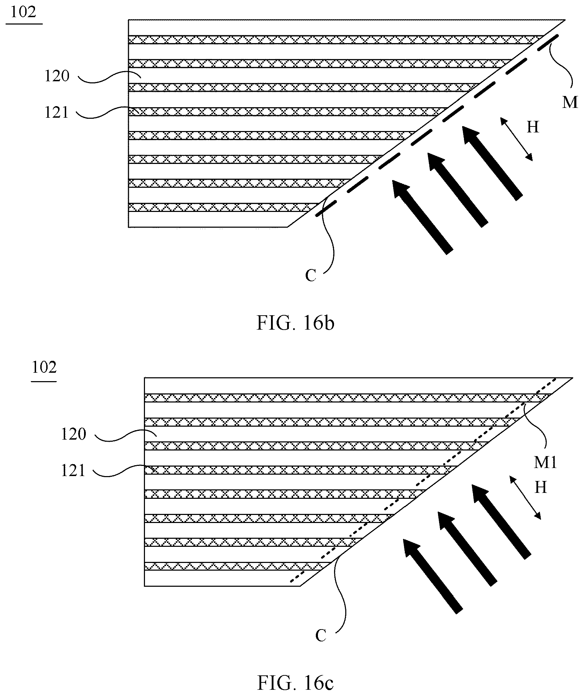

The magnetic lines passing through the insulating isolation film 30 from the first magnetic film 101 are perpendicular to the surface that is of the second magnetic film 102 and that is in contact with the insulating isolation film 30, that is, the inclined surface C shown in FIG. 16b, so that the magnetic lines can enter the magnetic sub-films 120 in the second magnetic film 102 shown in FIG. 16c. This is the same as Example 1. In this case, the eddy current M is induced in the alternating magnetic field at the section perpendicular to the direction of the magnetic lines, that is, the section parallel to the inclined surface C.

In addition, as shown in FIG. 16c, the eddy current M is separated into the plurality of sub-eddy currents M1 by the layers of magnetic sub-films 120. In addition, each sub-eddy current M1 enters one layer of magnetic sub-film 120. In this case, as shown in FIG. 8, each sub-eddy current M1 can be limited to each layer of magnetic sub-film 120, to reduce loss of the eddy current.

### Example 4

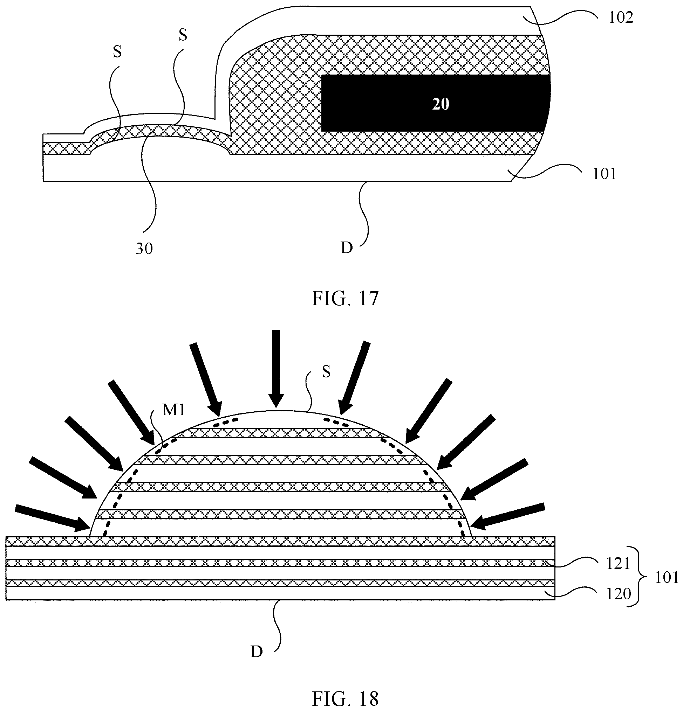

In this example, as shown in FIG. 17, the surface that is of the first magnetic film 101 and that is in contact with the insulating isolation film 30 and the surface that is of the second magnetic film 102 and that is in contact with the insulating isolation film 30 are curved surfaces S with same curvature. In this case, a thickness of the insulating isolation film 30 is the same at all positions.

In addition, the magnetic sub-films 120 and the insulating sub-films 121 in the first magnetic film 101 and the second magnetic film 102 are parallel to the lower surface D of the first magnetic film 101.

In this case, as shown in FIG. 18, the magnetic sub-films 120 and the insulating sub-films 121 in the first magnetic film 101 are exposed from the curved surface S that is of the first magnetic film 101 and that is in contact with the insulating isolation film 30.

On this basis, after the conductor 20 in the thin film inductor 01 is powered on, when the direction of the magnetic lines of the alternating magnetic field generated by the thin film inductor 01 is counterclockwise shown in FIG. 7b, the first magnetic film 101 in contact with the left-side insulating isolation film 30 in FIG. 7b is used as an example.

In this case, as shown in FIG. 18, the magnetic lines passing through the insulating isolation film 30 enter the magnetic sub-films 120 in the first magnetic film 101.

In this case, the sub-eddy current M1 is induced in the alternating magnetic field at a section perpendicular to a direction of a magnetic line. In this way, as shown FIG. 8, the sub-eddy currents M1 can be respectively limited to the magnetic sub-films 120, to reduce loss of the eddy current.

It should be noted that when the thickness of the insulating isolation film 30 does not need to be the same at all positions, in the magnetic core 10, only the surface that is of the second magnetic film 102 and that is in contact with the insulating isolation film 30 may be set to the curved surface S. Alternatively, the surface that is of the first magnetic film 101 and that is in contact with the insulating isolation film 30 is set to the curved surface S. A process of reducing loss of the eddy current at the position of the insulating isolation film 30 by using the surface S may be obtained in the same manner. Details are not described herein again.

It should be noted that the thin film inductor 01 shown in FIG. 17 also has the flattened dielectric layer 22, the interlayer dielectric layer 24, the seed layer 27, the upper support layer 28, and the adhesion layer 29. A manner of setting these thin films is the same as that described above. Details are not described herein again.

### Example 5:

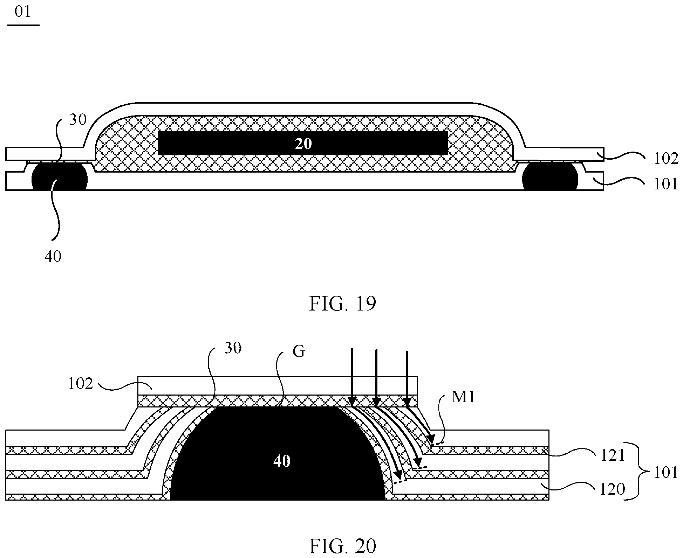

In this example, as shown in FIG. 19, the thin film inductor 01 further includes a support pad 40. The support pad 40 is located below the first magnetic film 101, and corresponds to the position of the insulating isolation film 30. A material forming the support pad 40 may be a non-magnetic material.

It should be noted that a part below the first magnetic film 101 is a side that is of the first magnetic film 101 and that is away from the second magnetic film 102.

As shown in FIG. 20, an upper surface G of the support pad 40 is in contact with the insulating isolation film 30. In addition, the first magnetic film 101 covers two sides of the upper surface G of the support pad 40. In the first magnetic film 101 covering the support pad 40, the magnetic sub-films 120 and the insulating sub-films 121 are in contact with the insulating isolation film 30.

In addition, the surface that is of the support pad 40 and that is in contact with the first magnetic film 101 is a curved surface. In this way, the magnetic sub-films 120 and the insulating sub-films 121 in the first magnetic film 101 alternately cover the curved surface of the support pad 40. In this way, the magnetic sub-films 120 and the insulating sub-films 121 in the first magnetic film 101 are also in a curved state. A curvature of these sub-films is the same as or similar to a curvature of the curved surface of the support pad 40 covered by these sub-films.

It may be learned from the foregoing that the magnetic sub-films 120 and the insulating sub-films 121 in the first magnetic film 101 are in the curved state. Therefore, in the first magnetic film 101, the magnetic sub-films 120 and the insulating sub-films 121 that cover the support pad 40 intersect a plane in which the insulating isolation film 30 is located. In this way, the magnetic sub-films 120 and the insulating sub-films 121 in the first magnetic film 101 can be exposed from the surface that is of the first magnetic film 101 and that is in contact with the insulating isolation film 30.

To simplify a process for preparing the support pad 40, in some embodiments of this application, the surface that is of the support pad 40 and that is in contact with the first magnetic film 101 is an arc surface. To improve stability of the support pad 40 in the thin film inductor 01, a lower surface of the support pad 40 is flush with the lower surface of the first magnetic film 101.

On this basis, after the conductor 20 in the thin film inductor 01 is powered on, when the direction of the magnetic lines of the alternating magnetic field generated by the thin film inductor 01 is counterclockwise shown in FIG. 7b, in FIG. 7b, a partial structure of the thin film inductor 01 at the position of the left-side insulating isolation film 30 is used as an example.

In this case, as shown in FIG. 20, a plurality of magnetic lines of the alternating magnetic field at the position of the insulating isolation film 30 pass through the insulating isolation film 30 from the second magnetic film 102, then separately enter the curved magnetic sub-films 120 in the first magnetic film 101 covering the support pad 40, and then go along a direction of laying the magnetic sub-films 120.

The magnetic sub-films 120 and the insulating sub-films 121 in the first magnetic film 101 covering the support pad 40 intersect the plane at which the insulating isolation film 30 is located. The plurality of magnetic lines passing through the insulating isolation film 30 can enter the layers of magnetic sub-films 120 in the first magnetic film 101. Therefore, the sub-eddy currents M1 are induced in the alternating magnetic field at sections perpendicular to the magnetic lines. As shown in FIG. 8, the sub-eddy current M1 is limited to the layers of magnetic sub-films 120, thereby reducing loss of the eddy current.

It should be noted that the thin film inductor 01 shown in FIG. 19 also has the flattened dielectric layer 22, the interlayer dielectric layer 24, the seed layer 27, the upper support layer 28, and the adhesion layer 29. A manner of setting these thin films is the same as that described above. Details are not described herein again.

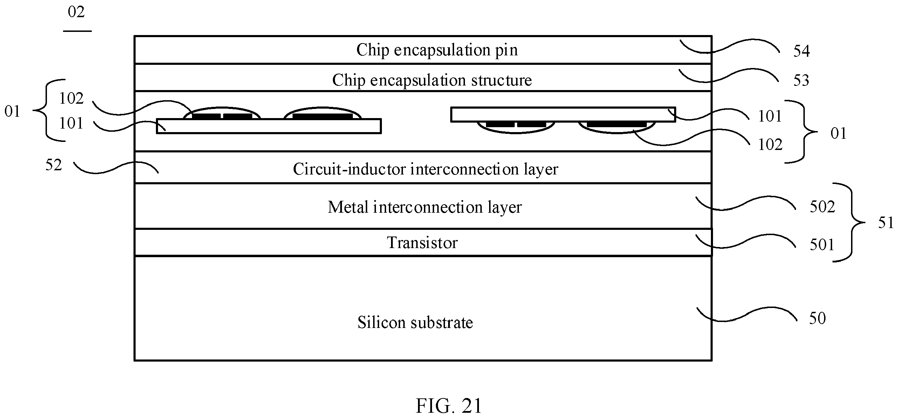

An embodiment of this application provides an integrated circuit 02. As shown in FIG. 21, the integrated circuit 02 includes a silicon substrate 50 and any foregoing described thin film inductor 01 disposed on the silicon substrate 50. The integrated circuit 02 has technical effects the same as the thin film inductor 01 provided in the foregoing embodiment. Details are not described herein again.

The material forming the silicon substrate 50 includes Si and a polymer (polymer).

It should be noted that the integrated circuit 02 may be a System-on-Chip (SoC), a central processing unit (central processing unit, CPU), a graphics processing unit (graphics processing unit, GPU), or a power management integrated circuit (power management integrate circuit, PMIC).

In addition, as shown in FIG. 21, the integrated circuit 02 further includes a circuit structure 51 disposed on the silicon substrate 50, a circuit-inductor interconnection layer 52 sequentially covering the circuit structure 51, and a chip encapsulation structure 53.

The circuit structure 51 includes a plurality of transistors 501, and a metal interconnection layer 502 configured to connect the plurality of transistors 501 together to form a circuit.

In this embodiment of this application, a type of the transistor 501 is not limited. The transistor 501 may be a transistor prepared by using a complementary metal oxide semiconductor (complementary metal oxide semiconductor, CMOS) process, a silicon germanium (SiGe) process, or a gallium nitride (GaN) process.

In addition, the metal interconnection layer 502 includes a plurality of dielectric layers or passivation layers (passivation layer), and a metal conducting wire embedded in the dielectric layers or the passivation layers. A material forming the dielectric layer or the passivation layer in the metal interconnection layer 502 includes any one of silicon dioxide (SiO₂), silicon nitride (Si₃N₄), and polyimide (polyimide).

On this basis, as shown in FIG. 21, the thin film inductor 01 is located between the circuit-inductor interconnection layer 52 and the chip encapsulation structure 53. The circuit-inductor interconnection layer 52 is configured to electrically connect the thin film inductor 01 to the circuit structure 51 located below the thin film inductor 01.

The manner of setting the thin film inductor 01 in the integrated circuit 02 may be that the first magnetic film 101 is closer to the silicon substrate 50 (the left-side thin film inductor 01) than the second magnetic film 102; or
the second magnetic film 102 in the thin film inductor 01 is closer to the silicon substrate 50 (the right-side thin film inductor 01) than the first magnetic film 101.

A package assembly structure configured to implement signal interconnection between a circuit and an inductor, for example, an interconnection path (Via), a solder pillar (solder pillar), a copper pillar (copper pillar), a micro bump (micro bump), or a lead bump (solder bump) is disposed in the circuit-inductor interconnection layer 52.

In addition, the chip encapsulation structure 53 may be prepared by using a wafer-level packaging (wafer-level packaging, WLP) process. The chip encapsulation structure includes an encapsulation substrate and encapsulation cabling disposed inside the encapsulation substrate.

On this basis, a chip encapsulation pin 54 is disposed above the chip encapsulation structure 53, so that the entire integrated circuit 02 can be connected to a printed circuit board (printed circuit board, PCB).

An embodiment of this application provides a terminal device. The terminal device includes at least one integrated circuit 02 described above.

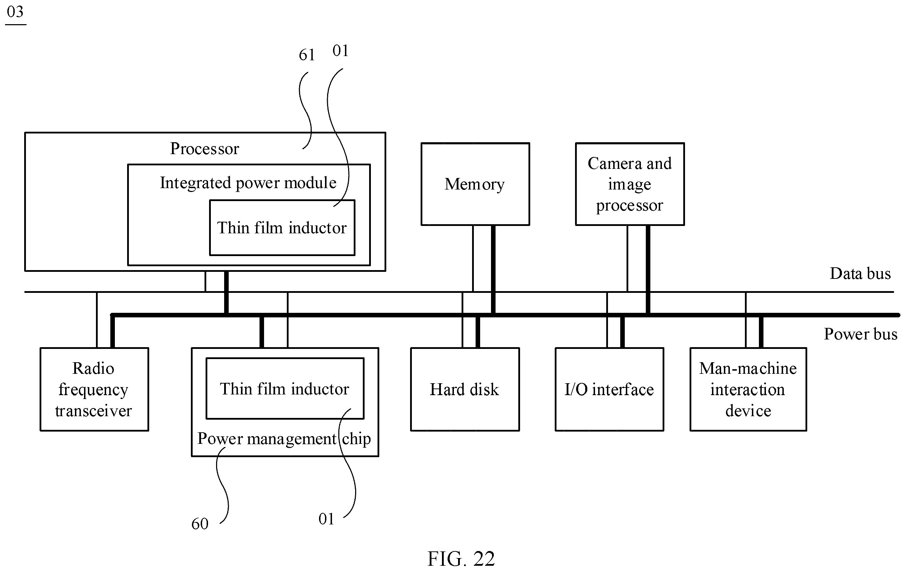

On this basis, as shown in FIG. 22, the mobile terminal 03 further includes a power management chip 60 and a power bus or a power delivery network of a power supply that is connected to the power management chip 60.

In this case, the power management chip 60 includes the integrated circuit 02, and the thin film inductor 01 is integrated into the integrated circuit 02.

In this case, the power management chip 60 may provide working voltage to other components of the terminal device 03 by using the power bus, for example, a radio frequency transceiver (radio frequency module), a memory, a hard disk, a camera and an image processor (imaging processing module), an input/output (I/O) interface, and a man-machine interaction device.

In addition, in some embodiments of this disclosure, the mobile terminal 03 further includes a processor 61 and a data bus (Data bus) connected to the processor 61. The processor 61 includes the integrated circuit 02. When the integrated circuit 02 is an integrated power module, the thin film inductor 01 is integrated into the integrated power module.

In this case, the processor 61 may provide working voltage to other components of the terminal device 03 by using the power bus, for example, the radio frequency transceiver, the memory, the hard disk, the camera and the image processor, the input/output interface, and the man-machine interaction device.

It should be noted that the processor 61 may be any one of a SoC, a CPU, and a GPU.

In addition, the terminal device 03 has technical effects the same as the integrated circuit 02 provided in the foregoing embodiment. Details are not described herein again.

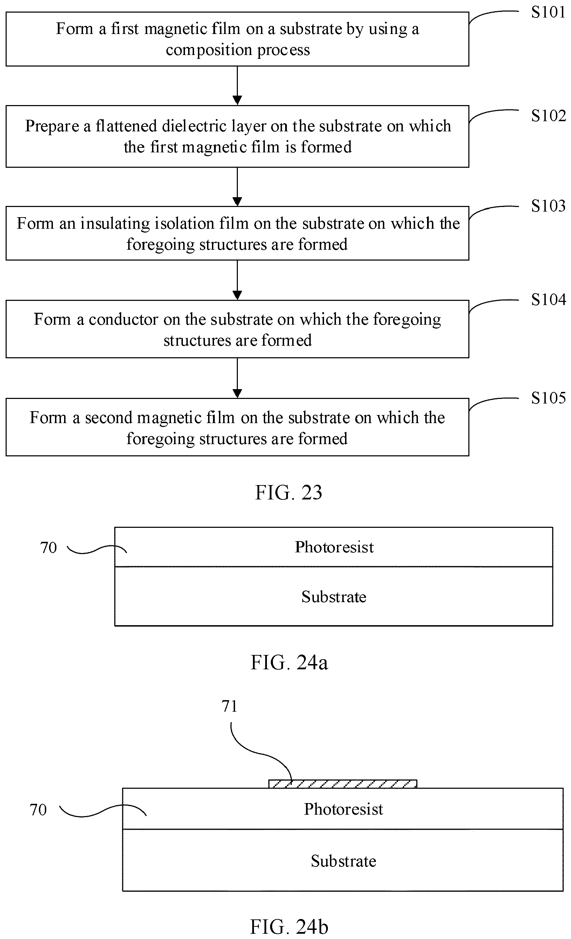

An embodiment of this application provides a method for preparing the thin film inductor 01 shown in FIG. 11a. As shown in FIG. 23, the method includes steps S101 to S105.

S101. Form a first magnetic film 101 on a substrate by using a composition process.

The first magnetic film 101 is a trapezoid frustum. An upper base E1 of the trapezoidal frustum is away from the substrate, and a lower base E2 is close to the substrate. magnetic sub-films 120 and insulating sub-films 121 in the first magnetic film 101 are exposed from side surfaces F of the trapezoid frustum.

It should be noted that the composition process in this embodiment of this application includes a photolithography process, or includes a photolithography process and an etching step, or includes printing, ink jetting, another process for forming a predetermined pattern, or the like.

The photolithography process indicates a process that includes processes of film forming, exposing, developing, and the like and in which a photoresist, a mask reticle, an exposure machine, and the like are used to form a pattern.

On this basis, in some embodiments of this application, a preparing process of preparing the first magnetic film 101 by using the lift-off process is as follows:

First, as shown in FIG. 24a, a photoresist 70 coats the substrate.

It should be noted that the photoresist 70 in this embodiment of this application may be a positive photoresist, or may be a negative photoresist. This is not limited in the present invention.

Next, as shown in FIG. 24b, a mask reticle 71 is configured to implement mask exposure on the photoresist 70.

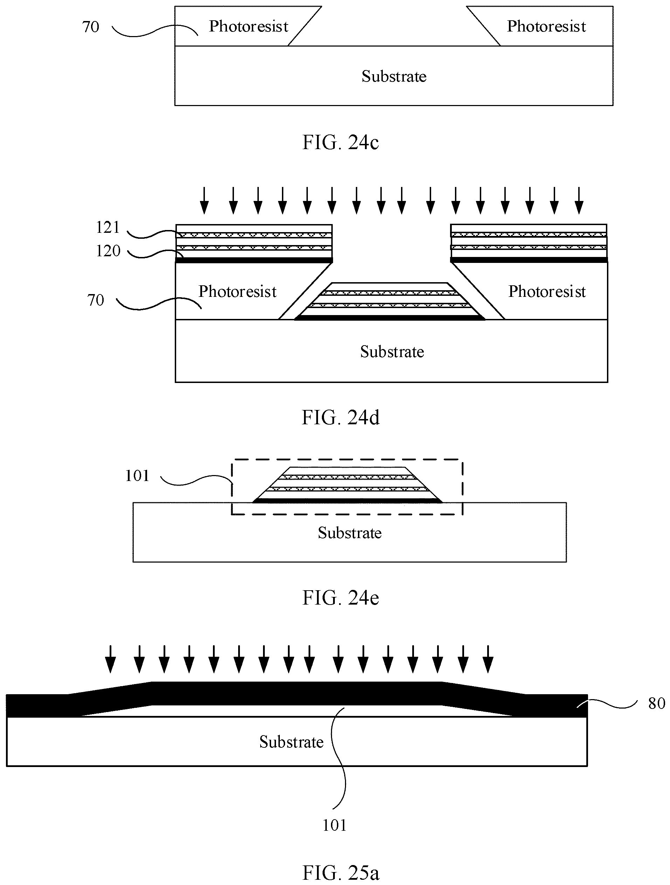

Then, as shown in FIG. 24c, a developing process is performed on the photoresist after the exposure performed by using the mask reticle. The photoresist shielded by the mask reticle 71 is not irradiated by light, and therefore is dissolved in a developing solution.

Afterwards, an adhesion layer (a black film layer in FIG. 24d) is deposited on the substrate on which the foregoing structures are formed. A physical vapor deposition process is used for a plurality of times to implement alternately sputtering, to form magnetic sub-films 120 and insulating sub-films 121 that are alternately disposed.

Finally, as shown in FIG. 24e, the photoresist 70 is lifted off, thereby forming the first magnetic film 101 in a trapezoidal frustum shape on the substrate.

S102. Prepare a flattened dielectric layer 22 on the substrate on which the first magnetic film 101 is formed.

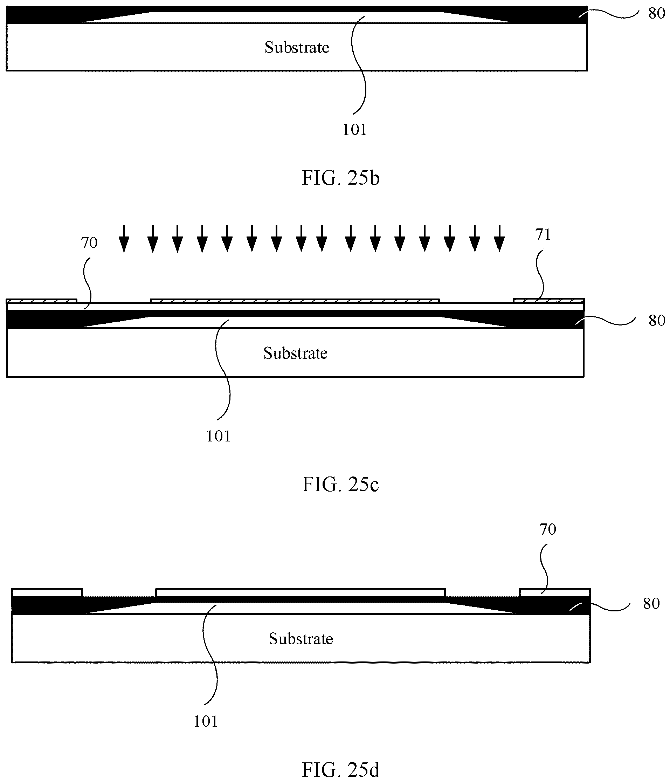

First, as shown in FIG. 25a, a first dielectric layer 80 is deposited. A CPM process is performed on the first dielectric layer 80, so that an upper surface of the first dielectric layer 80 is flat to some extent as shown in FIG. 25b.

Next, as shown in FIG. 25c, the first dielectric layer 80 is exposed by using the mask reticle 71 and the photoresist 70.

Then, the developing process is performed on the photoresist 70. As shown in FIG. 25d, a part that is of the photoresist 70 and that is irradiated by light is dissolved in the developing solution.

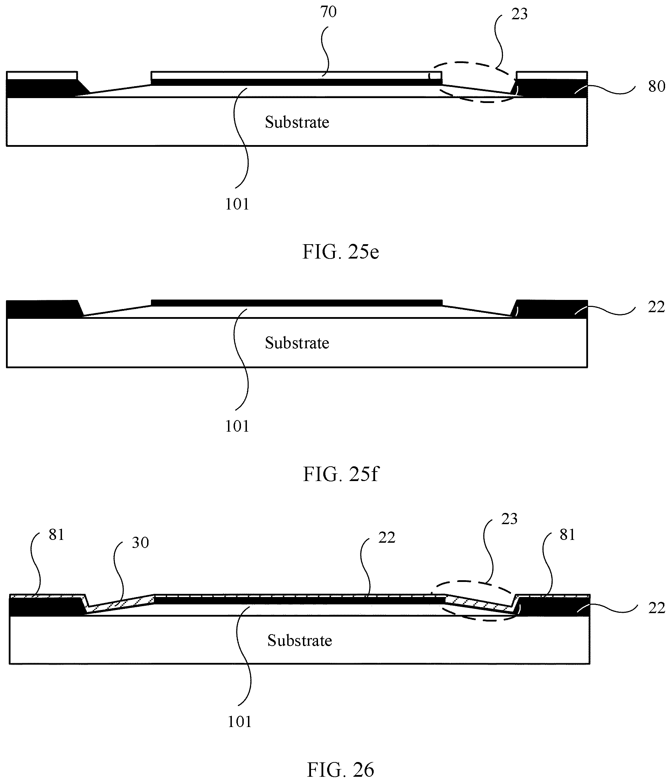

Afterwards, a dry etching process is used to etch a part that is the first dielectric layer 80 and that is not covered by the photoresist 70, to form a magnetic flux hole 23 shown in FIG. 25e. A part of a side surface F of the first magnetic film 101 in the trapezoidal frustum shape is exposed at a bottom of the magnetic flux hole 23.

A size of an opening of the magnetic flux hole 23 is controlled, so that the first dielectric layer 80 can cover a part of the side surface of the trapezoid frustum. In this way, the part of the side surface F of the first magnetic film 101 in the trapezoidal frustum shape is exposed in the magnetic flux hole 23, and the other part is covered by the first dielectric layer 80.

In addition, as shown in FIG. 25e, the first dielectric layer 80 further covers the upper base of the trapezoidal frustum.

As shown in FIG. 25f, after the photoresist 70 on the first dielectric layer 80 is lifted off, the first dielectric layer 80 formed by using the composition process may serve as the flattened dielectric layer 22.

S103. Form an insulating isolation film 30 on the substrate on which the foregoing structures are formed.

As shown in FIG. 26, a second dielectric layer 81 is deposited. The second dielectric layer 81 covers an upper surface of the first dielectric layer 80 and a side wall of the magnetic flux hole 23, and is in contact with the other part of the side surface of the trapezoidal frustum by using the magnetic flux hole 23.

A part that is of the second dielectric layer 81 and that is in contact with the side surface of the trapezoidal frustum serves as the insulating isolation film 30.

S104. Form a conductor 20 on the substrate on which the foregoing structures are formed.

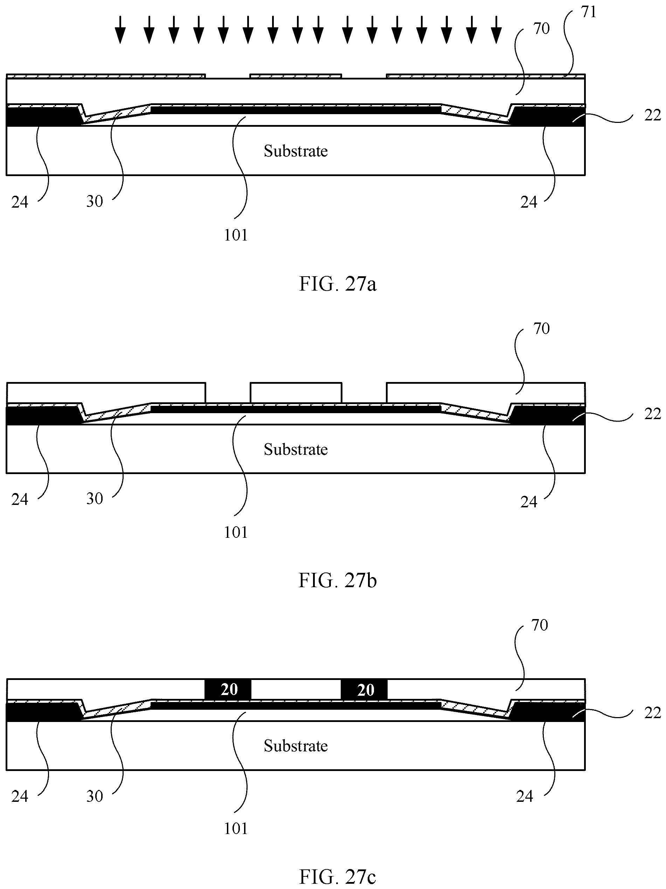

First, as shown in FIG. 27a, the photoresist 70 above the upper base E1 of the trapezoidal frustum, that is, the first magnetic film 101 is formed by using the composition process, and the photoresist is exposed by using the mask reticle 71.

Next, as shown in FIG. 27b, the developing process is used and performed on the photoresist 70 after the exposure, so that the photoresist 70 irradiated by light is removed through the developing process.

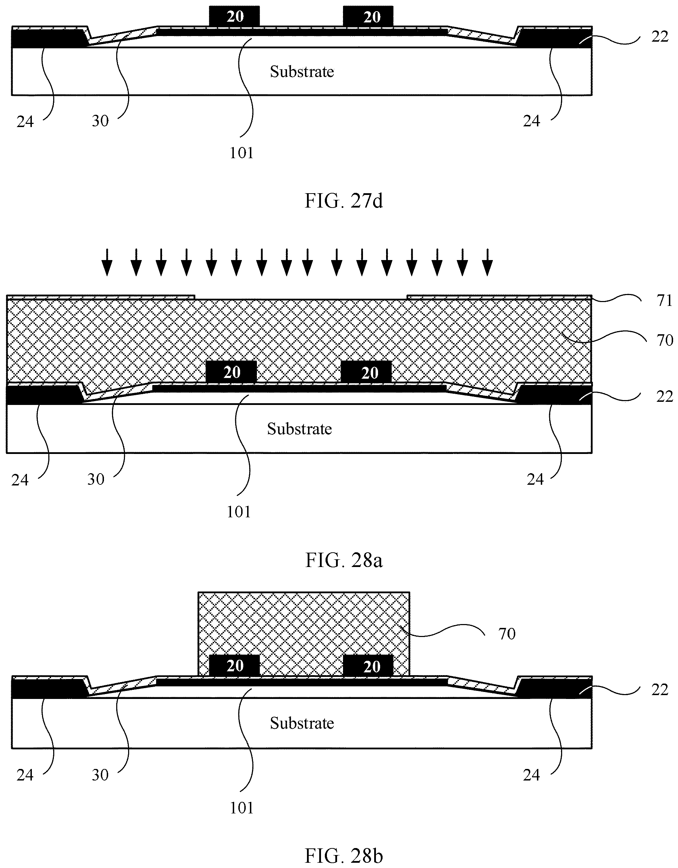

Afterwards, as shown in FIG. 27c, the conductor 20 is formed on the substrate on which the foregoing structures are formed. As shown in FIG. 27d, the photoresist 70 around the conductor 20 is lifted off. A material forming the conductor 20 may be at least one of copper (Cu), titanium (Ti), nickel (Ni), or gold (Au).

S105. Form a second magnetic film 102 on the substrate on which the foregoing structures are formed.

An accommodation cavity 21 for accommodating the conductor 20 is formed between the first magnetic film 101 and the second magnetic film 102.

For example, as shown in FIG. 28a, first, the photoresist 70 coats the structure of FIG. 27d. Because the photoresist 70 is used to form an upper support layer 28, the photoresist 70 has a relatively large thickness. Then, the photoresist 70 is exposed by using the mask reticle 71.

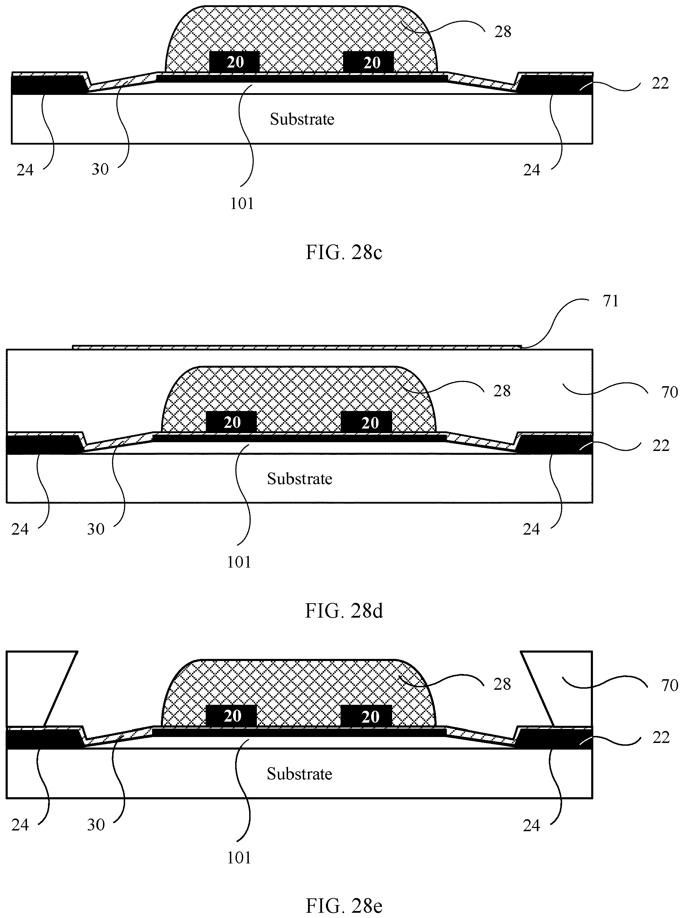

Next, as shown in FIG. 28b, the developing process is performed on the photoresist 70 after the exposure, and a thermal reflow (thermal reflow) process is performed on the photoresist 70 after the developing process, to form the upper support layer 28 shown in FIG. 28c.

Afterwards, as shown in FIG. 28d, the photoresist 70 coats the structure shown in FIG. 28c, and the photoresist 70 is exposed by using the mask reticle 71.

As shown in FIG. 28e, the developing process is performed on the photoresist 70 after the exposure.

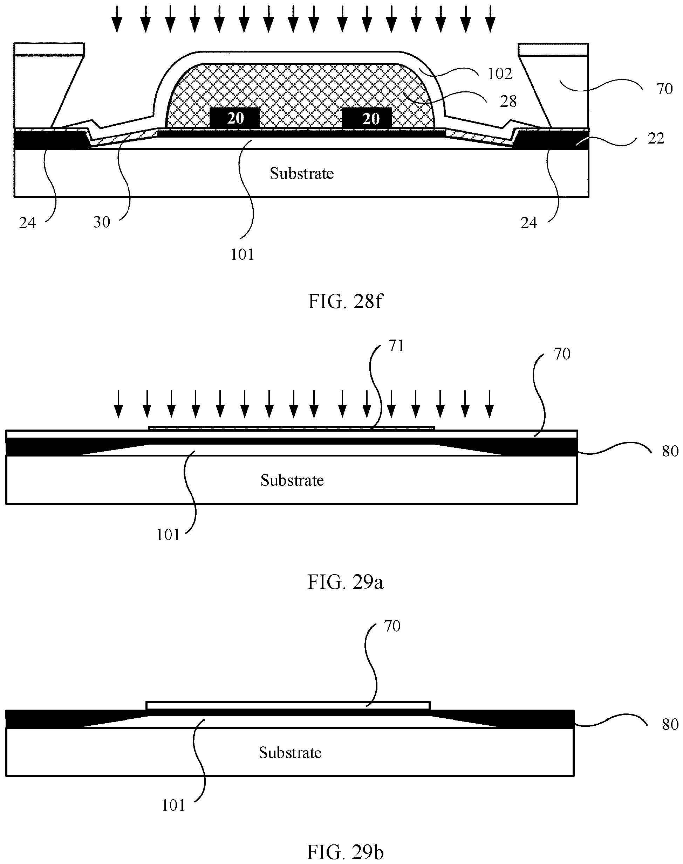

As shown in FIG. 28f, the physical vapor deposition process is used for a plurality of times to implement alternately sputtering, to form magnetic sub-films 120 and insulating sub-films 121 that are alternately disposed.

Finally, the remaining photoresist 70 is lifted off, to form the second magnetic film 102 shown in FIG. 11a.

It should be noted that, in the foregoing preparation method, because of a relatively small size of the opening of the magnetic flux hole 23, as shown in FIG. 28f, a tail of the prepared second magnetic film 102 covers a sidewall on a side that is of the magnetic flux hole 23 and that is away from the accommodation cavity 21, and covers, after a turning, an upper surface of the interlayer dielectric layer 24 connected to the sidewall.

In addition, an end that is of the tail 25 of the second magnetic film 102 and that is away from the accommodation cavity 21 has a taper angle β. The taper angle β is less than 90°.

The method for preparing the thin film inductor 01 has technical effects the same as the magnetic film inductor 01 provided in the foregoing embodiment. Details are not described herein again.

An embodiment of this application provides a method for preparing the thin film inductor 02 shown in FIG. 11d. The method still includes the foregoing steps S101 to S105. A structure of the thin film inductor 02 is different from the structure shown in FIG. 11a. Therefore, specific processes of some steps in the foregoing steps S101 to S105 are also different. The following describes in detail the specific processes of these steps.

First, step S101 is performed. A process of preparing the first magnetic film 101 is the same as the foregoing description. Details are not described herein again.

In a process of performing step S102, first, steps in FIG. 25a and FIG. 25b are performed. The first dielectric layer 80 is deposited on the substrate on which the first magnetic film 101 is formed. A flattening process is performed on the first dielectric layer 80.

Next, as shown in FIG. 29a, the photoresist 70 coats the substrate on which the foregoing structures are formed, and the photoresist 70 is exposed by using the mask reticle 71. Then, as shown in FIG. 29b, the developing process is performed on the photoresist 70 after the exposure.

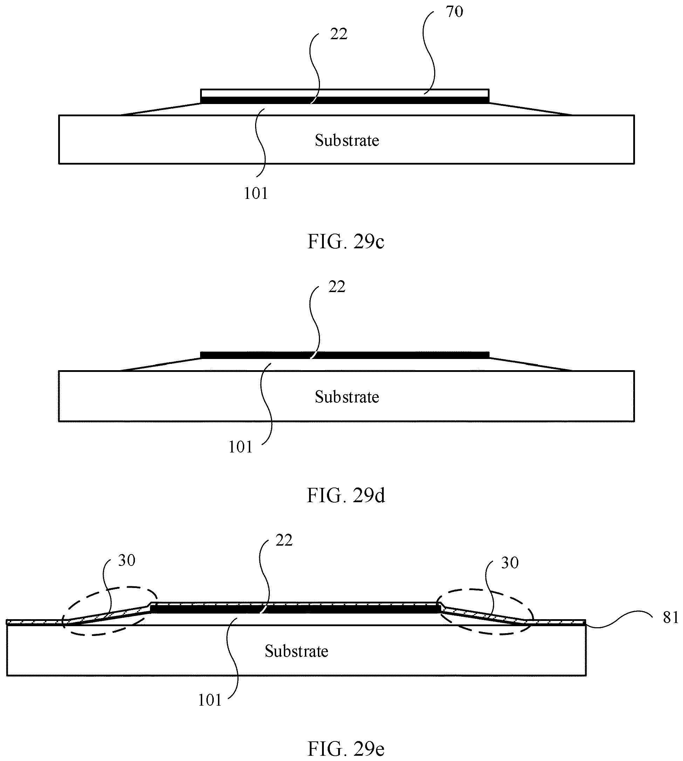

Afterwards, as shown in FIG. 29c, the first dielectric layer 80 that is not covered by the photoresist 70 is etched to form the flattened dielectric layer 22. The first dielectric layer 80 formed by using the composition process, that is, the flattened dielectric layer 22 covers the upper base E1 of the trapezoid frustum. As shown in FIG. 29d, the photoresist on a surface of the flattened dielectric layer 22 is removed.

In a process of performing step S103, as shown in FIG. 29e, the second dielectric layer 81 is deposited on the substrate on which the foregoing structures are formed.

The second dielectric layer 81 covers the flattened dielectric layer 22. In addition, a part that is of the second dielectric layer 81 and that fully covers the side surfaces of the trapezoid frustum, that is, the first magnetic film 101 serves as the insulating isolation film 30.

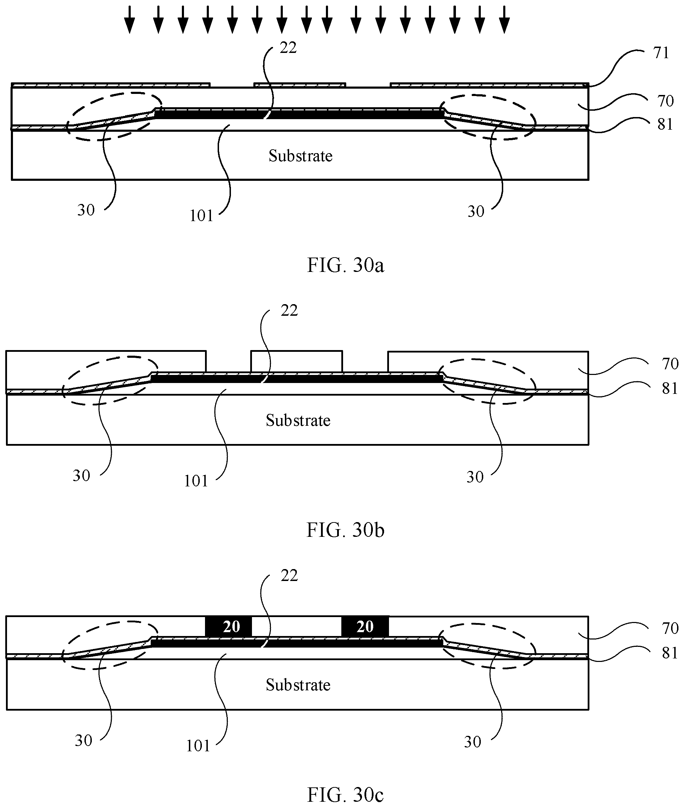

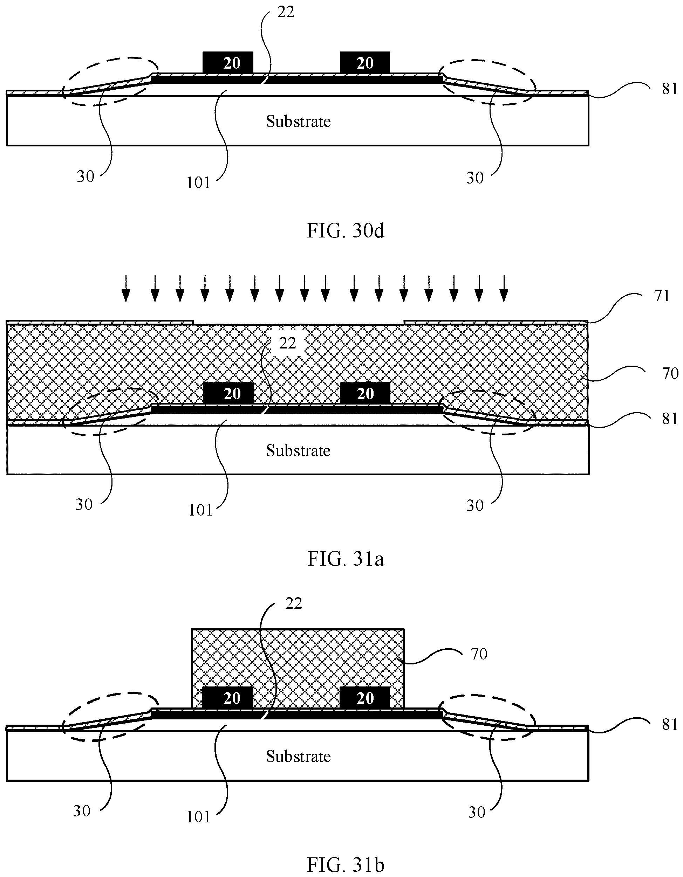

In a process of performing step S104, as shown in FIG. 30a, the photoresist 70 coats the substrate on which the insulating isolation film 30 is formed, and the photoresist 70 is exposed by using the mask reticle 71. As shown in FIG. 30b, the developing process is performed on the photoresist 70 after the exposure, to remove a part of the photoresist 70. As shown in FIG. 30c, the conductor 20 located above the upper base E1 of the trapezoidal frustum is formed by using the composition process. Finally, as shown in FIG. 30d, the photoresist 70 on a surface of the conductor 20 is lifted off.

In a process of performing step S105, as described above, as shown in FIG. 31a, first, the photoresist 70 coats the structure of FIG. 30d. Because the photoresist 70 is used to form the upper support layer 28, the photoresist 70 has a relatively large thickness. Next, the photoresist 70 is exposed by using the mask reticle 71.

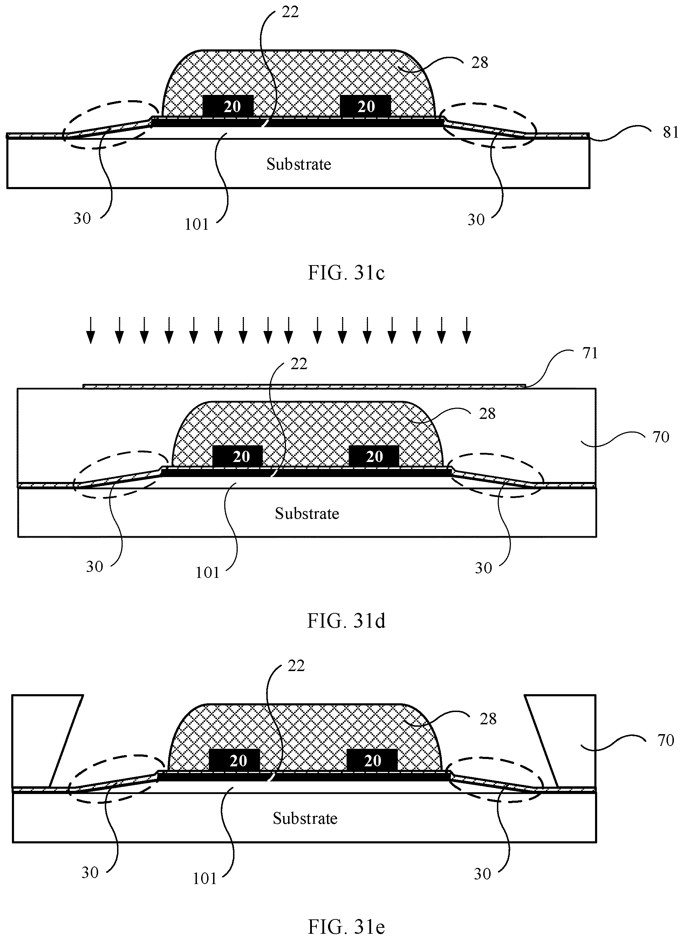

Then, as shown in FIG. 31b, the developing process is performed on the photoresist 70 after the exposure, and a thermal reflow process is performed on the photoresist 70 after the developing process, to form the upper support layer 28 shown in FIG. 31c.

Afterwards, as shown in FIG. 31d, the photoresist 70 coats the structure shown in FIG. 31c, and the photoresist 70 is exposed by using the mask reticle 71.

As shown in FIG. 31e, the developing process is performed on the photoresist 70 after the exposure.

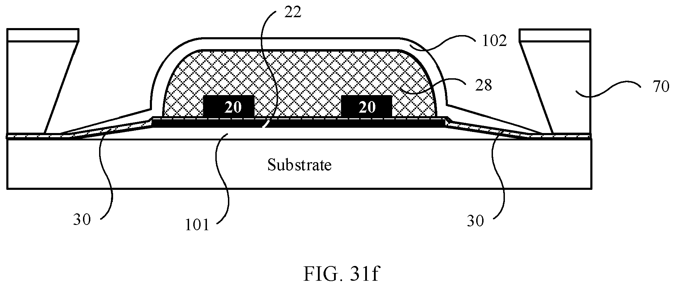

As shown in FIG. 31f, the physical vapor deposition process is used for a plurality of times to implement alternately sputtering, to form the magnetic sub-films 120 and the insulating sub-films 121 that are laminated and alternately disposed.

Finally, the remaining photoresist 70 is lifted off, to form the second magnetic film 102 shown in FIG. 11d.

It should be noted that in the foregoing preparation method, because the magnetic flux hole 23 does not need to be prepared at the first dielectric layer 80, as shown in FIG. 31f, the tail of the prepared second magnetic film 102 flatly covers the upper surface of the insulating isolation film 30. In addition, an end that is of the tail 25 of the second magnetic film 102 and that is away from the accommodation cavity 21 has a taper angle β. The taper angle β is less than 90°.

The method for preparing the thin film inductor 01 has technical effects the same as the magnetic film inductor 01 provided in the foregoing embodiment. Details are not described herein again.

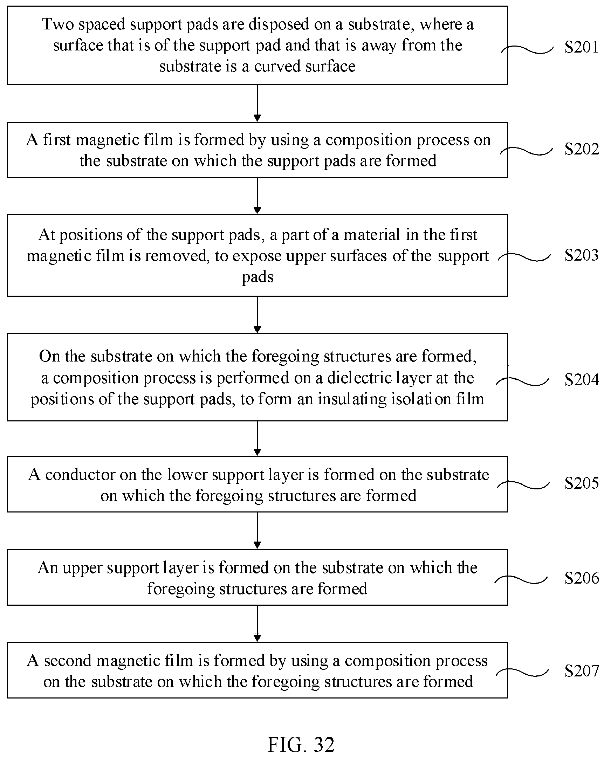

This application provides a method for preparing a thin film inductor 01. As shown in FIG. 32, the method includes steps S201 to S207.

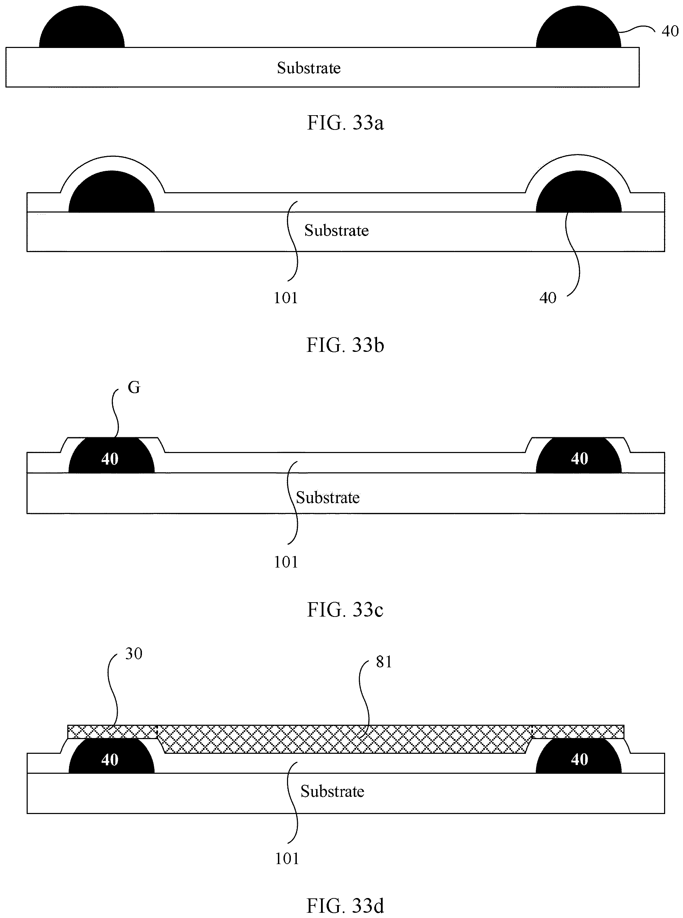

S201. As shown in FIG. 33a, two spaced support pads 40 are disposed on a substrate 02. A surface that is of the support pad 40 and that is away from the substrate 02 is a curved surface.

A material forming the support pad 40 may be a non-magnetic material.

It should be noted that when the thin film inductor 01 is integrated into an integrated circuit, the substrate 02 may be a silicon substrate.

In addition, to simplify a process of preparing the support pad 40, in step S101, a surface that is of the support pad 40 and that is away from the substrate 02 is an arc surface.

S202. As shown FIG. 33b, a first magnetic film 101 is formed by using a composition process on the substrate 02 on which the support pads 40 are formed.

The first magnetic film 101 includes magnetic sub-films 121 and insulating sub-films 120 that are alternately disposed. A method for preparing the first magnetic film 101 is the same as the method described above. Details are not described herein again.

S203. As shown in FIG. 33c, at positions of the support pads 40, a part of a material in the first magnetic film 101 is removed, to expose upper surfaces G of the support pads 40.

S204. On the substrate 02 on which the foregoing structures are formed, as shown in FIG. 33d, a composition process is performed on a dielectric layer at the positions of the support pads 40, for example, a dielectric layer with the same material as the second dielectric layer 81, to form an insulating isolation film 30.

As shown in FIG. 20, the formed insulating isolation film 30 covers the upper surfaces of the support pads 40, and sides of magnetic sub-films 120 and the insulating sub-films 121 in the first magnetic film 101 on two sides of the upper surfaces of the support pads 40.

It should be noted that a part of the second dielectric layer 81 except the insulating isolation film 30 may be used as a lower support layer 26.

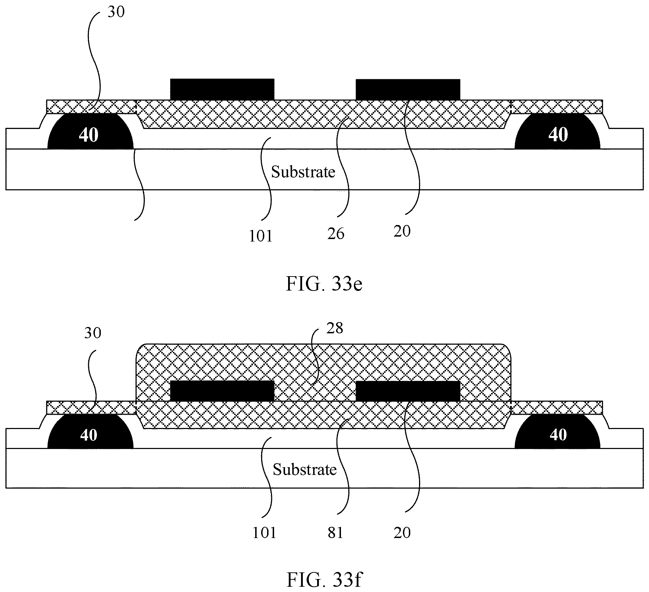

S205. As shown in FIG. 33e, a conductor 20 on the lower support layer 26 is formed on the substrate 02 on which the foregoing structures are formed. A process for preparing the conductor 20 is the same as the process described above. Details are not described herein again.

S206. As shown in FIG. 33f, an upper support layer 28 is formed on the substrate 02 on which the foregoing structures are formed. A process for preparing the upper support layer 28 is the same as the process described above. Details are not described herein again.

S207. As shown in FIG. 19, a second magnetic film 102 is formed by using a composition process on the substrate 02 on which the foregoing structures are formed.

The second magnetic film 102 includes magnetic sub-films 120 and insulating sub-films 121 that are alternately disposed. A method for preparing the second magnetic film 102 is the same as the method described above. Details are not described herein again.

The method for preparing the thin film inductor 01 has technical effects the same as the thin film inductor 01 provided in the foregoing embodiment. Details are not described herein again.

The foregoing descriptions are merely specific implementations of the present invention, but are not intended to limit the protection scope of the present invention. Any variation or replacement readily figured out by a person skilled in the art within the technical scope disclosed in the present invention shall fall within the protection scope of the present invention. Therefore, the protection scope of the present invention shall be subject to the protection scope of the claims.

## Claims

1. A thin film inductor, comprising:
a magnetic core (10), wherein the magnetic core (10) comprises a first magnetic film (101) and a second magnetic film (102), and an accommodation cavity (21) exists between the first magnetic film (101) and the second magnetic film (102);
a conductor (20), located in the accommodation cavity (21); and
an insulating isolation film (30), disposed on two sides of the conductor (20) and located between the first magnetic film (101) and the second magnetic film (102), wherein the insulating isolation film (30) is in contact with the first magnetic film (101) and the second magnetic film (102); wherein
the first magnetic film (101) and the second magnetic film (102) each comprise magnetic sub-films (120) and insulating sub-films (121);
in the first magnetic film (101), the magnetic sub-films (120) and the insulating sub-films (121) are alternately disposed;
in the second magnetic film (102), the magnetic sub-films (120) and the insulating sub-films (121) are alternately disposed;
**characterized in that** the magnetic sub-films (120) and the insulating sub-films (121) in the first magnetic film (101) are exposed from a surface that is of the first magnetic film (101) and that is in contact with the insulating isolation film (30); and/or, the magnetic sub-films (120) and the insulating sub-films (121) in the second magnetic film (102) are exposed from a surface that is of the second magnetic film (102) and that is in contact with the insulating isolation film (30).

2. The thin film inductor according to claim 1, wherein
the surface that is of the first magnetic film (101) and that is in contact with the insulating isolation film (30) and/or the surface that is of the second magnetic film (102) and that is in contact with the insulating isolation film (30) is an inclined surface;
the magnetic sub-films (120) and the insulating sub-films (121) in the first magnetic film (101) and the second magnetic film (102) are parallel to the lower surface of the first magnetic film (101); and
the lower surface of the first magnetic film (101) is a surface that is of the first magnetic film (101) and that is away from the second magnetic film (102).

3. The thin film inductor according to claim 1, wherein
the surface that is of the first magnetic film (101) and that is in contact with the insulating isolation film (30) and the surface that is of the second magnetic film (102) and that is in contact with the insulating isolation film (30) are inclined surfaces with a same slope.

4. The thin film inductor according to claim 2 or 3, wherein the first magnetic film (101) is a trapezoidal frustum, an upper base of the trapezoidal frustum is close to the second magnetic film (102), and a lower base is away from the second magnetic film (102); and
the thin film inductor further comprises:
a flattened dielectric layer (22), covering the upper base of the trapezoidal frustum and a part of side surfaces of the trapezoidal frustum;
a magnetic flux hole (23), prepared on the flattened dielectric layer (22), wherein the insulating isolation film (30) is located in the magnetic flux hole (23) and covers the other part of the side surfaces of the trapezoidal frustum; and
an interlayer dielectric layer (24), covering an upper base of the flattened dielectric layer (22) and a sidewall of the magnetic flux hole (23), wherein the interlayer dielectric layer and the insulating isolation film (30) are made of the same material and are an integrated structure.

5. The thin film inductor according to claim 4, wherein
a tail (25) of the second magnetic film (102) covers the sidewall on a side that is of the magnetic flux hole (23) and that is away from the accommodation cavity (21), and an upper surface that is of the interlayer dielectric layer and that is connected to the sidewall; and
an end that is of the tail (25) of the second magnetic film (102) and that is away from the accommodation cavity (21) has a taper angle, and the taper angle is from 10° to 90°.

6. The thin film inductor according to claim 2 or 3, wherein the first magnetic film (101) is a trapezoidal frustum, an upper base of the trapezoidal frustum is close to the second magnetic film (102), a lower base is away from the second magnetic film (102), and side surfaces of the trapezoidal frustum are fully covered by the insulating isolation film (30); and
the thin film inductor further comprises:
a flattened dielectric layer (22), covering the upper base of the trapezoidal frustum; and
an interlayer dielectric layer (24), covering the flattened dielectric layer (22), wherein the interlayer dielectric layer and the insulating isolation film (30) are made of the same material and are an integrated structure.

7. The thin film inductor according to claim 6, wherein an end that is away from the accommodation cavity (21) and that is of a part that is of the second magnetic film (102) and that is in contact with the insulating isolation film (30) has a taper angle, wherein the taper angle is from 10° to 90°.

8. The thin film inductor according to claim 1, wherein the surface that is of the first magnetic film (101) and that is in contact with the insulating isolation film (30) and/or the surface that is of the second magnetic film (102) and that is in contact with the insulating isolation film (30) are/is curved surfaces/a curved surface;
the magnetic sub-films (120) and the insulating sub-films (121) in the first magnetic film (101) and the second magnetic film (102) are parallel to the lower surface of the first magnetic film (101); and
the lower surface of the first magnetic film (101) is a surface that is of the first magnetic film (101) and that is away from the second magnetic film (102).

9. The thin film inductor according to claim 1, wherein
the thin film inductor further comprises a support pad (40), wherein the support pad (40) is located below the first magnetic film (101), and a part below the first magnetic film (101) is a side that is of the first magnetic film (101) and that is away from the second magnetic film (102);
an upper surface of the support pad (40) is in contact with the insulating isolation film (30);
the first magnetic film (101) covers two sides of the upper surface of the support pad (40);
in the first magnetic film (101) covering the support pad (40), the magnetic sub-films (120) and the insulating sub-films (121) are in contact with the insulating isolation film (30); and
a surface that is of the support pad (40) and that is in contact with the first magnetic film (101) is a curved surface.

10. The thin film inductor according to claim 9, wherein
the surface that is of the support pad (40) and that is in contact with the first magnetic film (101) is an arc surface; and
a lower surface of the support pad (40) is flush with a lower surface of the first magnetic film (101).

11. The thin film inductor according to any one of claims 1 to 10, wherein the thin film inductor further comprises:
a seed layer (27), located in the accommodation cavity (21), wherein the seed layer (27) is in contact with a surface that is of the conductor (20) and that is close to the first magnetic film (101);
an upper support layer (28), located in the accommodation cavity (21), wherein a surface of the conductor (20) except the surface in contact with the seed layer (27) is covered by the upper support layer (28); and
an adhesion layer (29), disposed on a surface that is of the second magnetic film (102) and that is close to the first magnetic film (101).

12. The thin film inductor according to any one of claims 1 to 11, wherein the first magnetic film (101) and the second magnetic film (102) are anisotropic; and
a length of the first magnetic film (101) is less than a length of the second magnetic film (102) in a direction of a hard axis of the thin film inductor.

13. The thin film inductor according to any one of claims 1 to 12, wherein the conductor (20) is at least one metal conducting wire, the thin film inductor comprises at least two magnetic cores (10), and two adjacent magnetic cores (10) are spaced along a length direction of the metal conducting wire.

14. The thin film inductor according to any one of claims 1 to 12, wherein the conductor (20) is a coil, and the thin film inductor comprises a first magnetic core (10) and a second magnetic core;
the coil comprises a plurality of first line segments (201) and a plurality of second line segments (202), and the first line segments (201) are disposed opposite to the second line segments (202); and
the plurality of first line segments (201) are located in the first magnetic core (10), and the plurality of second line segments (202) are located in the second magnetic core.

15. An integrated circuit, comprising a silicon substrate (50) and a thin film inductor, according to any one of claims 1 to 14, disposed on the silicon substrate (50).

16. The integrated circuit according to claim 15, wherein the integrated circuit further comprises a circuit structure (51) disposed on the silicon substrate (50), a circuit-inductor interconnection layer (52) sequentially covering the circuit structure (51), and a chip encapsulation structure (53);
the thin film inductor is located between the circuit-inductor interconnection layer (52) and the chip encapsulation structure (53), and the circuit-inductor interconnection layer (52) is configured to electrically connect the thin film inductor to the circuit structure (51); and
a first magnetic film (101) in the thin film inductor is closer to the silicon substrate (50) than a second magnetic film (102); or
a second magnetic film (102) in the thin film inductor is closer to the silicon substrate (50) than a first magnetic film (101).

17. A terminal device (3), comprising at least one integrated circuit according to claim 15 or 16, wherein
the terminal device (3) further comprises a power management chip (60) and a power bus connected to the power management chip (60), wherein the power management chip (60) comprises an integrated circuit; and/or
the terminal further comprises a processor (61) and a data bus connected to the processor (61), wherein the processor (61) comprises the integrated circuit.

18. A method for preparing the thin film inductor of claim 4, wherein the method comprises:
forming the first magnetic film (101) on a substrate by using a composition process, wherein the first magnetic film (101) is a trapezoidal frustum, an upper base of the trapezoidal frustum is away from the substrate, and a lower base is close to the substrate; and
and the insulating sub-films (121) in the first magnetic film (101) are exposed from side surfaces of the trapezoidal frustum;
depositing a first dielectric layer (80) on the substrate on which the first magnetic film (101) is formed, performing a flattening process on the first dielectric layer (80), and preparing a magnetic flux hole (23) on the first dielectric layer (80) by using the composition process, wherein the first dielectric layer (80) formed by using the composition process covers the upper base of the trapezoidal frustum and a part of the side surfaces of the trapezoidal frustum;
depositing a second dielectric layer (81) on the substrate on which the foregoing structures are formed, wherein the second dielectric layer (81) covers an upper surface of the first dielectric layer (80) and a sidewall of the magnetic flux hole (23), and is in contact with the other part of the side surfaces of the trapezoidal frustum by using the magnetic flux hole (23);
and a part that is of the second dielectric layer (81) and that is in contact with the side surfaces of the trapezoidal frustum serves as an insulating isolation film (30);
forming, on the substrate on which the insulating isolation film (30) is formed, the conductor (20) above the upper base of the trapezoidal frustum by using the composition process; and forming, on the substrate on which the conductor (20) is formed, the second magnetic film (102) by using the composition process, and the accommodation cavity (21) for accommodating the conductor (20) is formed between the first magnetic film (101) and the second magnetic film (102).

## Patentansprüche

1. Dünnfilminduktor, umfassend:
einen magnetischen Kern (10), wobei der magnetische Kern (10) einen ersten magnetischen Film (101) und einen zweiten magnetischen Film (102) umfasst, und ein Aufnahmehohlraum (21) zwischen dem ersten magnetischen Film (101) und dem zweiten magnetischen Film (102) vorhanden ist;
einen Leiter (20), der sich in dem Aufnahmehohlraum (21) befindet; und
einen isolierenden Isolierfilm (30), der auf zwei Seiten des Leiters (20) angeordnet ist und sich zwischen dem ersten magnetischen Film (101) und dem zweiten magnetischen Film (102) befindet, wobei der isolierende Isolierfilm (30) in Kontakt mit dem ersten magnetischen Film (101) und dem zweiten magnetischen Film (102) ist; wobei der erste magnetische Film (101) und der zweite magnetische Film (102) jeweils magnetische Subfilme (120) und isolierende Subfilme (121) umfassen;
in dem ersten magnetischen Film (101) die magnetischen Subfilme (120) und die isolierenden Subfilme (121) alternierend angeordnet sind;
in dem zweiten magnetischen Film (102) die magnetischen Subfilme (120) und die isolierenden Subfilme (121) alternierend angeordnet sind;
**dadurch gekennzeichnet, dass**
die magnetischen Subfilme (120) und die isolierenden Subfilme (121) in dem ersten magnetischen Film (101) von einer Oberfläche exponiert sind, die von dem ersten magnetischen Film (101) ist und die in Kontakt mit dem isolierenden Isolierfilm (30) ist; und/oder die magnetischen Subfilme (120) und die isolierenden Subfilme (121) in dem zweiten magnetischen Film (102) von einer Oberfläche exponiert sind, die von dem zweiten magnetischen Film (102) ist und die in Kontakt mit dem isolierenden Isolierfilm (30) ist.

2. Dünnfilminduktor nach Anspruch 1, wobei
die Oberfläche, die von dem ersten magnetischen Film (101) ist und die in Kontakt mit dem isolierenden Isolierfilm (30) ist, und/oder die Oberfläche, die von dem zweiten magnetischen Film (102) ist und die in Kontakt mit dem isolierenden Isolierfilm (30) ist, eine geneigte Oberfläche ist;
die magnetischen Subfilme (120) und die isolierenden Subfilme (121) in dem ersten magnetischen Film (101) und dem zweiten magnetischen Film (102) parallel zu der unteren Oberfläche des ersten magnetischen Films (101) sind; und
die untere Oberfläche des ersten magnetischen Films (101) eine Oberfläche ist, die von dem ersten magnetischen Film (101) ist und die von dem zweiten magnetischen Film (102) entfernt liegt.

3. Dünnfilminduktor nach Anspruch 1, wobei
die Oberfläche, die von dem ersten magnetischen Film (101) ist und die in Kontakt mit dem isolierenden Isolierfilm (30) ist, und die Oberfläche, die von dem zweiten magnetischen Film (102) ist und die in Kontakt mit dem isolierenden Isolierfilm (30) ist, geneigte Oberflächen mit derselben Neigung sind.

4. Dünnfilminduktor nach Anspruch 2 oder 3, wobei der erste magnetische Film (101) ein trapezförmiger Stumpf ist, eine obere Basis des trapezförmigen Stumpfes nahe an dem zweiten magnetischen Film (102) liegt, und eine untere Basis von dem zweiten magnetischen Film (102) entfernt liegt; und
der Dünnfilminduktor des Weiteren umfasst:
eine abgeflachte Dielektrikumschicht (22), die die obere Basis des trapezförmigen Stumpfes und einen Teil der Seitenoberflächen des trapezförmigen Stumpfes bedeckt;
ein Magnetflussloch (23), das auf der abgeflachten Dielektrikumschicht (22) hergestellt worden ist, wobei der isolierende Isolierfilm (30) sich in dem Magnetflussloch (23) befindet und den anderen Teil der Seitenoberflächen des trapezförmigen Stumpfes bedeckt; und
eine Zwischenschicht-Dielektrikumschicht (24), die eine obere Basis der abgeflachten Dielektrikumschicht (22) und eine Seitenwand des Magnetflusslochs (23) bedeckt, wobei die Zwischenschicht-Dielektrikumschicht und der isolierende Isolierfilm (30) aus dem gleichen Material gefertigt sind und eine integrierte Struktur sind.

5. Dünnfilminduktor nach Anspruch 4, wobei
ein Ausläufer (25) des zweiten magnetischen Films (102) die Seitenwand auf einer Seite, die von dem Magnetflussloch (23) ist und die von dem Aufnahmehohlraum (21) entfernt liegt, und eine obere Oberfläche bedeckt, die von der Zwischenschicht-Dielektrikumschicht ist und die mit der Seitenwand verbunden ist; und
ein Ende, das von dem Ausläufer (25) des zweiten magnetischen Films (102) ist und das von dem Aufnahmehohlraum (21) entfernt liegt, einen Schrägwinkel aufweist, und der Schrägwinkel 10° bis 90° beträgt.

6. Dünnfilminduktor nach Anspruch 2 oder 3, wobei der erste magnetische Film (101) ein trapezförmiger Stumpf ist, eine obere Basis des trapezförmigen Stumpfes nahe an dem zweiten magnetischen Film (102) liegt, eine untere Basis von dem zweiten magnetischen Film (102) entfernt liegt, und Seitenoberflächen des trapezförmigen Stumpfes vollständig von dem isolierenden Isolierfilm (30) bedeckt sind; und
der Dünnfilminduktor des Weiteren umfasst:
eine abgeflachte Dielektrikumschicht (22), die die obere Basis des trapezförmigen Stumpfes bedeckt; und
eine Zwischenschicht-Dielektrikumschicht (24), die die abgeflachte Dielektrikumschicht (22) bedeckt, wobei die Zwischenschicht-Dielektrikumschicht und der isolierende Isolierfilm (30) aus dem gleichen Material gefertigt sind und eine integrierte Struktur sind.

7. Dünnfilminduktor nach Anspruch 6, wobei ein Ende, das von dem Aufnahmehohlraum (21) entfernt liegt und das von einem Teil ist, das von dem zweiten magnetischen Film (102) ist und das in Kontakt mit dem isolierenden Isolierfilm (30) ist, einen Schrägwinkel aufweist, wobei der Schrägwinkel 10° bis 90° beträgt.

8. Dünnfilminduktor nach Anspruch 1, wobei die Oberfläche, die von dem ersten magnetischen Film (101) ist und die in Kontakt mit dem isolierenden Isolierfilm (30) ist, und/oder die Oberfläche, die von dem zweiten magnetischen Film (102) ist und die in Kontakt mit dem isolierenden Isolierfilm (30) ist, eine gekrümmte Oberfläche/gekrümmte Oberflächen ist/sind;
die magnetischen Subfilme (120) und die isolierenden Subfilme (121) in dem ersten magnetischen Film (101) und dem zweiten magnetischen Film (102) parallel zu der unteren Oberfläche des ersten magnetischen Films (101) sind; und
die untere Oberfläche des ersten magnetischen Films (101) eine Oberfläche ist, die von dem ersten magnetischen Film (101) ist und die von dem zweiten magnetischen Film (102) entfernt liegt.

9. Dünnfilminduktor nach Anspruch 1, wobei
der Dünnfilminduktor des Weiteren ein Trägerpad (40) umfasst, wobei das Trägerpad (40) sich unter dem ersten magnetischen Film (101) befindet, und ein Teil unter dem ersten magnetischen Film (101) eine Seite ist, die von dem ersten magnetischen Film (101) ist und die von dem zweiten magnetischen Film (102) entfernt liegt;
eine obere Oberfläche des Trägerpads (40) in Kontakt mit dem isolierenden Isolierfilm (30) ist;
der erste magnetische Film (101) zwei Seiten der oberen Oberfläche des Trägerpads (40) bedeckt;
in dem ersten magnetischen Film (101), der das Trägerpad (40) bedeckt, die magnetischen Subfilme (120) und die isolierenden Subfilme (121) in Kontakt mit dem isolierenden Isolierfilm (30) sind; und
eine Oberfläche, die von dem Trägerpad (40) ist und die in Kontakt mit dem ersten magnetischen Film (101) ist, eine gekrümmte Oberfläche ist.

10. Dünnfilminduktor nach Anspruch 9, wobei
die Oberfläche, die von dem Trägerpad (40) ist und die in Kontakt mit dem ersten magnetischen Film (101) ist, eine Bogenoberfläche ist; und
eine untere Oberfläche des Trägerpads (40) bündig mit einer unteren Oberfläche des ersten magnetischen Films (101) ist.

11. Dünnfilminduktor nach einem der Ansprüche 1 bis 10, wobei der Dünnfilminduktor des Weiteren umfasst:
eine Impfschicht (27), die sich in dem Aufnahmehohlraum (21) befindet, wobei die Impfschicht (27) in Kontakt mit einer Oberfläche ist, die von dem Leiter (20) ist und die nahe an dem ersten magnetischen Film (101) liegt;
eine obere Trägerschicht (28), die sich in dem Aufnahmehohlraum (21) befindet, wobei eine Oberfläche des Leiters (20), mit Ausnahme der Oberfläche in Kontakt mit der Impfschicht (27), mit der oberen Trägerschicht (28) bedeckt ist; und
eine Adhäsionsschicht (29), die auf einer Oberfläche angeordnet ist, die von dem zweiten magnetischen Film (102) ist und die nahe an dem ersten magnetischen Film (101) liegt.

12. Dünnschichtinduktor nach einem der Ansprüche 1 bis 11, wobei der erste magnetische Film (101) und der zweite magnetische Film (102) anisotrop sind; und
eine Länge des ersten magnetischen Films (101) kleiner als eine Länge des zweiten magnetischen Films (102) in einer Richtung einer harten Achse des Dünnfilminduktors ist.

13. Dünnfilminduktor nach einem der Ansprüche 1 bis 12, wobei der Leiter (20) mindestens ein Metallleiterdraht ist, der Dünnfilminduktor mindestens zwei magnetische Kerne (10) umfasst, und zwei benachbarte magnetische Kerne (10) entlang einer Längsrichtung des Metallleiterdrahts beabstandet sind.

14. Dünnfilminduktor nach einem der Ansprüche 1 bis 12, wobei der Leiter (20) eine Wendel ist und der Dünnfilminduktor einen ersten magnetischen Kern (10) und einen zweiten magnetischen Kern umfasst;
die Wendel eine Vielzahl von ersten Liniensegmenten (201) und eine Vielzahl von zweiten Liniensegmenten (202) umfasst, und die ersten Liniensegmente (201) gegenüber von den zweiten Liniensegmenten (202) angeordnet sind; und
die Vielzahl der ersten Liniensegmente (201) sich in dem ersten magnetischen Kern (10) befindet, und die Vielzahl der zweiten Liniensegmente (202) sich in dem zweiten magnetischen Kern befindet.

15. Integrierte Schaltung, umfassend ein Siliciumsubstrat (50) und einen Dünnfilminduktor gemäß einem der Ansprüche 1 bis 14, der auf dem Siliciumsubstrat (50) angeordnet ist.

16. Integrierte Schaltung nach Anspruch 15, wobei die integrierte Schaltung des Weiteren eine Schaltungsstruktur (51), die auf dem Siliciumsubstrat (50) angeordnet ist, eine Schaltung-Induktor-Interkonnektionsschicht (52), die sequentiell die Schaltungsstruktur (51) bedeckt, und eine Chipverkapselungsstruktur (53) umfasst;
der Dünnfilminduktor sich zwischen der Schaltung-Induktor-Interkonnektionsschicht (52) und der Chipverkapselungsstruktur (53) befindet, und die Schaltung-Induktor-Interkonnektionsschicht (52) ausgestaltet ist, um den Dünnfilminduktor mit der Schaltungsstruktur (51) zu verbinden; und
ein erster magnetischer Film (101) in dem Dünnfilminduktor näher an dem Siliciumsubstrat (50) als ein zweiter magnetischer Film (102) liegt; oder
der zweite magnetische Film (102) in dem Dünnfilminduktor näher an dem Siliciumsubstrat (50) liegt als ein erster magnetischer Film (101).

17. Endgerät (3), umfassend mindestens eine integrierte Schaltung gemäß Anspruch 15 oder 16, wobei
das Endgerät (3) des Weiteren einen Powermanagement-Chip (60) und einen mit dem Powermanagement-Chip (60) verbundenen Powerbus umfasst, wobei der Powermanagement-Chip (60) eine integrierte Schaltung umfasst; und/oder
das Endgerät des Weiteren einen Prozessor (61) und einen mit dem Prozessor (61) verbundenen Datenbus umfasst, wobei der Prozessor (61) die integrierte Schaltung umfasst.

18. Verfahren zur Herstellung des Dünnfilminduktors gemäß Anspruch 4, wobei das Verfahren umfasst:
Bilden des ersten magnetischen Films (101) auf einem Substrat durch Verwenden eines Kompositionsprozesses, wobei der erste magnetische Film (101) ein trapezförmiger Stumpf ist, eine obere Basis des trapezförmigen Stumpfes von dem Substrat entfernt liegt, und eine untere Basis nahe an dem Substrat liegt; und die isolierenden Subfilme (121) in dem ersten magnetischen Film (101) von Seitenoberflächen des trapezförmigen Stumpfes exponiert sind;
Abscheiden einer ersten Dielektrikumschicht (80) auf dem Substrat, auf dem der erste magnetische Film (101) gebildet ist, Durchführen eines Abflachungsprozesses auf der ersten Dielektrikumschicht (80), und Herstellen eines Magnetflusslochs (23) auf der ersten Dielektrikumschicht (80) unter Verwendung des Kompositionsprozesses, wobei die erste Dielektrikumschicht (80), die unter Verwendung des Kompositionsprozesses gebildet ist, die obere Basis des trapezförmigen Stumpfes und einen Teil der Seitenoberflächen des trapezförmigen Stumpfes bedeckt;
Abscheiden einer zweiten Dielektrikumschicht (81) auf dem Substrat, auf dem die vorhergehenden Strukturen gebildet sind, wobei die zweite Dielektrikumschicht (81) eine obere Oberfläche der ersten Dielektrikumschicht (80) und eine Seitenwand des Magnetflusslochs (23) bedeckt und unter Verwendung des Magnetflussloches (23) in Kontakt mit dem anderen Teil der Seitenoberflächen des trapezförmigen Stumpfes ist; und ein Teil, der von der zweiten Dielektrikumschicht (81) ist und der in Kontakt mit den Seitenoberflächen des trapezförmigen Stumpfes ist, als isolierender Isolierfilm (30) dient;
Bilden des Leiters (20) oberhalb der oberen Basis des trapezförmigen Stumpfes auf dem Substrat, auf dem der isolierende Isolierfilm (30) gebildet ist, unter Verwendung des Kompositionsprozesses, und
Bilden des zweiten magnetischen Films (102) auf dem Substrat, auf dem der Leiter (20) gebildet ist, unter Verwendung des Kompositionsprozesses, wobei der Aufnahmehohlraum (21) zum Aufnehmen des Leiters (20) zwischen dem ersten magnetischen Film (101) und dem zweiten magnetischen Film (102) gebildet ist.

## Revendications

1. Inductance à films minces, comprenant :
un noyau magnétique (10), le noyau magnétique (10) comprenant un premier film magnétique (101) et un deuxième film magnétique (102), et une cavité de réception (21) étant ménagée entre le premier film magnétique (101) et le deuxième film magnétique (102) ;
un conducteur (20), situé dans la cavité de réception (21) ; et
un film d'isolement isolant (30), agencé entre deux côtés du conducteur (20) et situé entre le premier film magnétique (101) et le deuxième film magnétique (102), le film d'isolement isolant (30) étant au contact du premier film magnétique (101) et du deuxième film magnétique (102) ;
le premier film magnétique (101) et le deuxième film magnétique (102) comprenant chacun des sous-films magnétiques (120) et des sous-films isolants (121) ;
dans le premier film magnétique (101), les sous-films magnétiques (120) et les sous-films isolants (121) étant agencés en alternance ;
dans le deuxième film magnétique (102), les sous-films magnétiques (120) et les sous-films isolants (121) étant agencés en alternance ;
**caractérisée en ce que**
les sous-films magnétiques (120) et les sous-films isolants (121) dans le premier film magnétique (101) sont exposés depuis une surface qui est celle du premier film magnétique (101) et qui est au contact du film d'isolement isolant (30) ; et/ou les sous-films magnétiques (120) et les sous-films isolants (121) dans le deuxième film magnétique (102) sont exposés depuis une surface qui est celle du deuxième film magnétique (102) et qui est au contact du film d'isolement isolant (30).

2. Inductance à films minces selon la revendication 1,
la surface qui est celle du premier film magnétique (101) et qui est au contact du film d'isolement isolant (30) et/ou la surface qui est celle du deuxième film magnétique (102) et qui est au contact du film d'isolement isolant (30) étant des surfaces inclinées/une surface inclinée ;
les sous-films magnétiques (120) et les sous-films isolants (121) dans le premier film magnétique (101) et le deuxième film magnétique (102) étant parallèles à la surface inférieure du premier film magnétique (101) ; et
la surface inférieure du premier film magnétique (101) étant une surface qui est celle du premier film magnétique (101) et qui est éloignée du deuxième film magnétique (102).

3. Inductance à films minces selon la revendication 1,
la surface qui est celle du premier film magnétique (101) et qui est au contact du film d'isolement isolant (30) et la surface qui est celle du deuxième film magnétique (102) et qui est au contact du film d'isolement isolant (30) étant des surfaces inclinées de même pente.

4. Inductance à films minces selon la revendication 2 ou 3, le premier film magnétique (101) étant un tronc trapézoïdal, une base supérieure du tronc trapézoïdal étant proche du deuxième film magnétique (102), et une base inférieure étant éloignée du deuxième film magnétique (102) ; et
l'inductance à films minces comprenant en outre :
une couche diélectrique planarisée (23), recouvrant la base supérieure du tronc trapézoïdal et une partie de surfaces latérales du tronc trapézoïdal ;
un trou de flux magnétique (23), élaboré sur la couche diélectrique planarisée (22), le film d'isolement isolant (30) étant situé dans le trou de flux magnétique (23) et recouvrant l'autre partie des surfaces latérales du tronc trapézoïdal ; et
une couche diélectrique intercalaire (24), recouvrant une base supérieure de la couche diélectrique planarisée (22) et une paroi latérale du trou de flux magnétique (23), la couche diélectrique intercalaire et le film d'isolement isolant (30) étant constitués du même matériau et formant une structure intégrée.

5. Inductance à films minces selon la revendication 4,
une queue (25) du deuxième film magnétique (102) recouvrant la paroi latérale d'un côté qui est celui du trou de flux magnétique (23) et qui est éloigné de la cavité de réception (21), et une surface supérieure qui est celle de la couche diélectrique intercalaire et qui est reliée à la paroi latérale ; et
une extrémité qui est celle de la queue (25) du deuxième film magnétique (102) et qui est éloignée de la cavité de réception (21) présentant un angle d'effilement, et l'angle d'effilement étant compris entre 10° et 90°.

6. Inductance à films minces selon la revendication 2 ou 3, le premier film magnétique (101) étant un tronc trapézoïdal, une base supérieure du tronc trapézoïdal étant proche du deuxième film magnétique (102), une base inférieure étant éloignée du deuxième film magnétique (102), et des surfaces latérales du tronc trapézoïdal étant entièrement recouvertes par le film d'isolement isolant (30) ; et
l'inductance à films minces comprenant en outre :
une couche diélectrique planarisée (22), recouvrant la base supérieure du tronc trapézoïdal ; et
une couche diélectrique intercalaire (24), recouvrant la couche diélectrique planarisée (22), la couche diélectrique intercalaire et le film d'isolement isolant (30) étant constitués du même matériau et formant une structure intégrée.

7. Inductance à films minces selon la revendication 6, une extrémité qui est éloignée de la cavité de réception (21) et qui est celle d'une partie qui est celle du deuxième film magnétique (102) et qui est au contact du film d'isolement isolant (30) présentant un angle d'effilement, l'angle d'effilement étant compris entre 10° et 90°.

8. Inductance à films minces selon la revendication 1, la surface qui est celle du premier film magnétique (101) et qui est au contact du film d'isolement isolant (30) et/ou la surface qui est celle du deuxième film magnétique (102) et qui est au contact du film d'isolement isolant (30) étant des surfaces incurvées/une surface incurvée ;
les sous-films magnétiques (120) et les sous-films isolants (121) dans le premier film magnétique (101) et le deuxième film magnétique (102) étant parallèles à la surface inférieure du premier film magnétique (101) ; et
la surface inférieure du premier film magnétique (101) étant une surface qui est celle du premier film magnétique (101) et qui est éloignée du deuxième film magnétique (102).

9. Inductance à films minces selon la revendication 1,
l'inductance à films minces comprenant en outre un plot de support (40), le plot de support (40) étant situé au-dessous du premier film magnétique (101), et une partie au-dessous du premier film magnétique (101) étant un côté qui est celui du premier film magnétique (101) et qui est éloigné du deuxième film magnétique (102) ;
une surface supérieure du plot de support (40) étant au contact du film d'isolement isolant (30) ;
le premier film magnétique (101) recouvrant deux côtés de la surface supérieure du plot de support (40) ;
dans le premier film magnétique (101) recouvrant le plot de support (40), les sous-films magnétiques (120) et les sous-films isolants (121) étant au contact du film d'isolement isolant (30) ; et
une surface qui est celle du plot de support (40) et qui est au contact du premier film magnétique (101) étant une surface incurvée.

10. Inductance à films minces selon la revendication 9,
la surface qui est celle du plot de support (40) et qui est au contact du premier film magnétique (101) étant une surface en arc ; et
une surface inférieure du plot de support (40) affleurant une surface inférieure du premier film magnétique (101).

11. Inductance à films minces selon l'une quelconque des revendications 1 à 10, l'inductance à films minces comprenant en outre :
une couche de germe (27), située dans la cavité de réception (21), la couche de germe (27) étant au contact d'une surface qui est celle du conducteur (20) et qui est proche du premier film magnétique (101) ;
une couche de support supérieure (28), située dans la cavité de réception (21), une surface du conducteur (20) hormis la surface au contact de la couche de germe (27) étant recouverte par la couche de support supérieure (28) ; et
une couche d'adhésion (29), agencée sur une surface qui est celle du deuxième film magnétique (102) et qui est proche du premier film magnétique (101).

12. Inductance à films minces selon l'une quelconque des revendications 1 à 11, le premier film magnétique (101) et le deuxième film magnétique (102) étant anisotropes ; et une longueur du premier film magnétique (101) étant inférieure à une longueur du deuxième film magnétique (102) dans une direction d'un axe difficile de l'inductance à films minces.

13. Inductance à films minces selon l'une quelconque des revendications 1 à 12, le conducteur (20) étant au moins un fil conducteur métallique, l'inductance à films minces comprenant au moins deux noyaux magnétiques (10), et deux noyaux magnétiques (10) adjacents étant espacés dans le sens de la longueur du fil conducteur métallique.

14. Inductance à films minces selon l'une quelconque des revendications 1 à 12, le conducteur (20) étant une bobine, et l'inductance à films minces comprenant un premier noyau magnétique (10) et un deuxième noyau magnétique ;
la bobine comprenant une pluralité de premiers segments de ligne (201) et une pluralité de deuxièmes segments de ligne (202), et les premiers segments de ligne (201) étant agencés à l'opposé des deuxièmes segments de ligne (202) ; et
la pluralité de premiers segments de ligne (201) étant situés dans le premier noyau magnétique (10), et la pluralité de deuxièmes segments de ligne (202) étant situés dans le deuxième noyau magnétique.

15. Circuit intégré, comprenant un substrat de silicium (50) et une inductance à films minces, selon l'une quelconque des revendications 1 à 14, agencée sur le substrat de silicium (50).

16. Circuit intégré selon la revendication 15, le circuit intégré comprenant en outre une structure de circuit (51) agencée sur le substrat de silicium (50), une couche d'interconnexion circuit-inductance (52) recouvrant séquentiellement la structure de circuit (51), et une structure d'encapsulation de puce (53) ;
l'inductance à films minces étant située entre la couche d'interconnexion circuit-inductance (52) et la structure d'encapsulation de puce (53), et la couche d'interconnexion circuit-inductance (52) étant configurée pour connecter électriquement l'inductance à films minces à la structure de circuit (51) ; et
un premier film magnétique (101) dans l'inductance à films minces étant plus proche du substrat de silicium (50) qu'un deuxième film magnétique (102) ; ou
un deuxième film magnétique (102) dans l'inductance à films minces étant plus proche du substrat de silicium (50) qu'un premier film magnétique (101).

17. Dispositif terminal (3), comprenant au moins un circuit intégré selon la revendication 15 ou 16,
le dispositif terminal (3) comprenant en outre une puce de gestion de l'alimentation (60) et un bus d'alimentation connecté à la puce de gestion de l'alimentation (60), la puce de gestion de l'alimentation (60) comprenant un circuit intégré ; et/ou
le terminal comprenant en outre un processeur (61) et un bus de données connecté au processeur (61), le processeur (61) comprenant le circuit intégré.

18. Procédé d'élaboration de l'inductance à films minces selon la revendication 4, le procédé comprenant :
la formation du premier film magnétique (101) sur un substrat au moyen d'un processus de structuration,
le premier film magnétique (101) étant un tronc trapézoïdal, une base supérieure du tronc trapézoïdal étant éloignée du substrat, et une base inférieure étant proche du substrat ; et
les sous-films isolants (121) dans le premier film magnétique (101) étant exposés depuis des surfaces latérales du tronc trapézoïdal ;
le dépôt d'une première couche diélectrique (80) sur le substrat sur lequel est formé le premier film magnétique (101), la réalisation d'un processus de planarisation sur la première couche diélectrique (80), et l'élaboration d'un trou de flux magnétique (23) sur la première couche diélectrique (80) au moyen du processus de structuration, la première couche diélectrique (80) formée au moyen du processus de structuration recouvrant la base supérieure du tronc trapézoïdal et une partie des surfaces latérales du tronc trapézoïdal ;
le dépôt d'une deuxième couche diélectrique (81) sur le substrat sur lequel sont formées les structures précédentes, la deuxième couche diélectrique (81) recouvrant une surface supérieure de la première couche diélectrique (80) et une paroi latérale du trou de flux magnétique (23), et étant au contact de l'autre partie des surfaces latérales du tronc trapézoïdal au moyen du trou de flux magnétique (23) ; et une partie qui est celle de la deuxième couche diélectrique (81) et qui est au contact des surfaces latérales du tronc trapézoïdal jouant le rôle d'un film d'isolement isolant (30) ;
la formation, sur le substrat sur lequel est formé le film d'isolement isolant (30), du conducteur (20) au-dessus de la base supérieure du tronc trapézoïdal au moyen du processus de structuration ; et
la formation, sur le substrat sur lequel est formé le conducteur (20), du deuxième film magnétique (102) au moyen du processus de structuration,
et la cavité de réception (21) destinée à recevoir le conducteur (20) étant formée entre le premier film magnétique (101) et le deuxième film magnétique (102).
